# EUROPEAN PATENT APPLICATION

(11) **EP 4 481 819 A1**
(43) Date of publication of application: **25.12.2024**
(21) Application number: 23756417.4
(22) Date of filing: 15.02.2023
(51) Int. Cl.: H01L 25/18, H01L 23/12, H01L 23/32, H01L 25/065, H01L 25/07, H05K 3/46

(54) **SEMICONDUCTOR PACKAGE, SEMICONDUCTOR PACKAGE INTERMEDIATE BODY, REWIRING LAYER CHIP, REWIRING LAYER CHIP INTERMEDIATE BODY, SEMICONDUCTOR PACKAGE MANUFACTURING METHOD, AND SEMICONDUCTOR PACKAGE INTERMEDIATE BODY MANUFACTURING METHOD**

(30) Priority: 15.02.2022 JP 2022021617; 29.07.2022 JP 2022122120
(71) Applicant: Dai Nippon Printing Co., Ltd., Tokyo 162-8001 (JP)
(72) Inventor: KURAMOCHI, Satoru, Tokyo 162-8001 (JP)
(74) Representative: Müller-Boré & Partner Patentanwälte PartG mbB
(86) International application number: PCT/JP2023/005328
(87) International publication number: WO 2023/157892

(57) **Abstract**

A semiconductor package includes an interposer, a redistribution layer chip adjacent to the interposer, and a semiconductor element that overlaps the interposer and the redistribution layer chip. The redistribution layer chip includes a redistribution element that has a surface overlapping the semiconductor element and a first mold resin layer that is mounted to an opposite surface of the redistribution element and that contains resin. The opposite surface is opposite the surface of the redistribution element overlapping the semiconductor element. The redistribution element includes an insulating layer that has an insulation property and a first redistribution layer that is covered by the insulating layer. The first redistribution layer includes a first conductive portion that is at least partly located on the surface of the redistribution element overlapping the semiconductor element. The interposer includes a second redistribution layer that includes a second conductive portion that is located on a surface of the interposer overlapping the semiconductor element. The semiconductor element is electrically connected to the first conductive portion and the second conductive portion.

## Description

### Technical Field

An embodiment of the present disclosure relates to a semiconductor package, a semiconductor package intermediate, a redistribution layer chip, a redistribution layer chip intermediate, a method of manufacturing a semiconductor package, and a method of manufacturing a semiconductor package intermediate.

### Background Art

Attention is paid to a packaging technique for mounting multiple semiconductor elements that have different functions such as a CPU and a memory on a single substrate with high density. The substrate that electrically connects the multiple semiconductor elements is also referred to as an interposer. For example, PTL 1 and PTL 2 disclose a semiconductor package including an interposer that includes a through-electrode and a semiconductor element that is mounted to the interposer.

In recent years, attention has been paid to a FOWLP (Fan Out Wafer Level Package) as a technique for achieving the higher density of semiconductor elements. An example of the FOWLP will be described. A wiring layer is first formed on a substrate in the form of a wafer such as an 8-inch wafer. Subsequently, a semiconductor element is mounted to the substrate. Subsequently, a mold resin layer that seals the wiring layer and the semiconductor element is formed above the substrate. When the semiconductor element is connected to, for example, another wiring substrate, a structure that includes the wiring layer, the semiconductor element, and the mold resin layer is separated from the substrate. The FOWLP enables the wiring layer to be formed up to a region outside the semiconductor element.

### Citation List

### Patent Literature

PTL 1: Japanese Patent No. 6014907
PTL 2: Japanese Patent No. 6159820

### Summary

### Technical Problem

A FOPLP (Fan Out Panel Level Package) is known as a technique for achieving higher productivity than that of the FOWLP. As for the FOPLP, a substrate in the form of a larger panel than a wafer is used. For example, fourth generation glass, sixth generation glass, eighth generation glass, or tenth generation glass, for example, is used as the substrate. However, there is a possibility that a large exposure device needs to be introduced to form a wiring layer on a large substrate. As a result, equipment costs can increase.

It is an object of an embodiment of the present disclosure to provide a semiconductor package, a semiconductor package intermediate, a redistribution layer chip, a redistribution layer chip intermediate, a method of manufacturing a semiconductor package, and a method of manufacturing a semiconductor package intermediate that can effectively solve the problems.

### Solution to Problem

An embodiment of the present disclosure relates to [1] to [21] described below.
[1] A semiconductor package includes:
   an interposer;
   a redistribution layer chip adjacent to the interposer; and
   a semiconductor element that overlaps the interposer and the redistribution layer chip.

The redistribution layer chip includes a redistribution element that has a surface overlapping the semiconductor element and a first mold resin layer that is mounted to an opposite surface of the redistribution element and that contains resin, the opposite surface being opposite the surface of the redistribution element overlapping the semiconductor element.

The redistribution element includes an insulating layer that has an insulation property and a first redistribution layer that is covered by the insulating layer, and the first redistribution layer includes a first conductive portion that is at least partly located on the surface of the redistribution element overlapping the semiconductor element.

The interposer includes a second redistribution layer that includes a second conductive portion that is located on a surface of the interposer overlapping the semiconductor element.

The semiconductor element is electrically connected to the first conductive portion and the second conductive portion.

[2] The semiconductor package described in [1] further includes: a support carrier that faces the semiconductor element with the interposer and the redistribution layer chip interposed therebetween and that supports the interposer and the redistribution layer chip.

The support carrier is separable from the interposer and the redistribution layer chip.

[3] The semiconductor package described in [1] or [2] further includes: a second mold resin layer that covers the interposer and the redistribution layer chip, that is mounted to the interposer and the redistribution layer chip, and that holds the semiconductor element.

[4] As for the semiconductor package described in any one of [1] to [3], a linear expansion coefficient of the first mold resin layer is lower than a linear expansion coefficient of the insulating layer.

[5] As for the semiconductor package described in any one of [1] to [4], a Young's modulus of the first mold resin layer is more than a Young's modulus of the insulating layer.

[6] As for the semiconductor package described in any one of [1] to [5], bending stiffness of the first mold resin layer is more than bending stiffness of the insulating layer.

[7] As for the semiconductor package described in any one of [1] to [6], a thickness of the first mold resin layer is more than a thickness of the insulating layer.

[8] As for the semiconductor package described in any one of [1] to [7], the first mold resin layer contains a particulate filler that is dispersed in the resin.

[9] As for the semiconductor package described in [8], thermal conductivity of the filler is more than thermal conductivity of the resin.

[10] As for the semiconductor package described in [8] or [9], the filler is composed of an inorganic material.

[11] As for the semiconductor package, color of the filler is black.

[12] As for the semiconductor package described in any one of [1] to [11], the redistribution layer chip further includes a through-electrode that is located in a through-hole that is formed in the first mold resin layer.

[13] As for the semiconductor package described in any one of [1] to [12], the first conductive portion includes a first wiring, and the second conductive portion includes a second wiring, and a line width of the first wiring is less than a line width of the second wiring.

[14] As for the semiconductor package described in any one of [1] to [13], the first conductive portion includes a first wiring, and a line width of the first wiring is 10 µm or less.

[15] As for the semiconductor package described in any one of [1] to [14], the resin that is contained in the first mold resin layer is at least epoxy resin, polyimide, acryl resin, bismaleimide, polybenzoxazole, or benzocyclobutene.

[16] A semiconductor package intermediate includes:
an interposer;
a redistribution layer chip adjacent to the interposer; and
a support carrier substrate that supports the interposer and the redistribution layer chip.

The redistribution layer chip includes a redistribution element and a mold resin layer that is mounted to the redistribution element and that contains resin, and the redistribution layer chip is mounted to the support carrier substrate with the mold resin layer connected to the support carrier substrate.

The support carrier substrate is separable from the interposer and the redistribution layer chip.

The redistribution element includes an insulating layer that has an insulation property and a first redistribution layer that is covered by the insulating layer, the first redistribution layer includes a first conductive portion that is at least partly located on a surface opposite a surface of the redistribution element to which the mold resin layer is mounted, and the interposer includes a second redistribution layer that includes a second conductive portion that is located on a surface opposite a surface that faces the support carrier substrate.

[17] A redistribution layer chip includes:
a redistribution element that includes an insulating layer having an insulation property and a redistribution layer covered by the insulating layer and that has a first surface and a second surface opposite the first surface, the redistribution layer including a conductive portion that is at least partly located at the first surface; and
a mold resin layer that is mounted to the second surface and that contains resin.

[18] The redistribution layer chip described in [17] further includes: an adhesive layer that is mounted to a surface opposite a surface of the mold resin layer that is mounted to the second surface, and the adhesive layer has heat-sensitive adhesiveness, or photosensitive adhesiveness, or pressure-sensitive adhesiveness.

[19] A redistribution layer chip intermediate includes:
a redistribution element portion that includes an insulating layer having an insulation property and multiple redistribution layers covered by the insulating layer and that has a first surface and a second surface opposite the first surface, each of the multiple redistribution layers including a conductive portion that is at least partly located at the first surface;
a mold resin layer portion that is mounted to the second surface and that contains resin; and
a chip carrier substrate that is joined to the first surface.

[20] A method of manufacturing a semiconductor package includes:
a step of placing a redistribution layer chip adjacent to an interposer; and
a step of mounting a semiconductor element that overlaps the interposer and the redistribution layer chip.
The redistribution layer chip includes a redistribution element that has a surface overlapping the semiconductor element and a first mold resin layer that is mounted to an opposite surface of the redistribution element and that contains resin, the opposite surface being opposite the surface of the redistribution element overlapping the semiconductor element,
The redistribution element includes an insulating layer that has an insulation property and a first redistribution layer that is covered by the insulating layer, the first redistribution layer includes a first conductive portion that is at least partly located on the surface of the redistribution element overlapping the semiconductor element, and the interposer includes a second redistribution layer that includes a second conductive portion that is located on a surface of the interposer overlapping the semiconductor element.
At the step of mounting the semiconductor element, the semiconductor element is electrically connected to the first conductive portion and the second conductive portion.

[21] A method of manufacturing a semiconductor package intermediate includes:
a step of preparing a support carrier substrate;
a step of forming an interposer above the support carrier substrate; and
a step of mounting, to the support carrier substrate, a redistribution layer chip adjacent to the interposer.

The redistribution layer chip includes a redistribution element and a mold resin layer that is mounted to the redistribution element and that contains resin, and the redistribution layer chip is mounted to the support carrier substrate with the mold resin layer connected to the support carrier substrate.

The support carrier substrate is separable from the interposer and the redistribution layer chip.

The redistribution element includes an insulating layer that has an insulation property and a first redistribution layer that is covered by the insulating layer, the first redistribution layer includes a first conductive portion that is at least partly located on a surface opposite a surface of the redistribution element to which the mold resin layer is mounted.

The interposer includes a second redistribution layer that includes a second conductive portion that is located on a surface opposite a surface that faces the support carrier substrate.

### Advantageous Effects

According to an embodiment of the present disclosure, a large semiconductor package can be provided at low costs.

### Brief Description of Drawings

[Fig. 1] Fig. 1 is a plan view of a semiconductor package according to an embodiment.
[Fig. 2] Fig. 2 is a sectional view of the semiconductor package in Fig. 1 taken along line A-A.
[Fig. 3] Fig. 3 is an enlarged sectional view of a redistribution layer chip that is included in the semiconductor package in Fig. 2.
[Fig. 4] Fig. 4 is a sectional view of the redistribution layer chip in Fig. 3 taken along line B-B.
[Fig. 5] Fig. 5 is a sectional view of the redistribution layer chip before the redistribution layer chip is incorporated as a portion of the semiconductor package in Fig. 1.
[Fig. 6] Fig. 6 is a diagram for describing a method of manufacturing the redistribution layer chip in Fig. 5.
[Fig. 7A] Fig. 7A is a diagram for describing the method of manufacturing the redistribution layer chip in Fig. 5.
[Fig. 7B] Fig. 7B is a plan view that corresponds to Fig. 7A.
[Fig. 8] Fig. 8 is a diagram for describing the method of manufacturing the redistribution layer chip in Fig. 5.
[Fig. 9A] Fig. 9A is a diagram for describing the method of manufacturing the redistribution layer chip in Fig. 5.
[Fig. 9B] Fig. 9B is a plan view that corresponds to Fig. 9A.
[Fig. 10A] Fig. 10A is a diagram for describing the method of manufacturing the redistribution layer chip in Fig. 5.
[Fig. 10B] Fig. 10B is a plan view that corresponds to Fig. 10A.
[Fig. 11] Fig. 11 is a diagram for describing a method of manufacturing the semiconductor package in Fig. 1.
[Fig. 12A] Fig. 12A is a diagram for the method of manufacturing the semiconductor package in Fig. 1.
[Fig. 12B] Fig. 12B is a diagram for describing the method of manufacturing the semiconductor package in Fig. 1.
[Fig. 12C] Fig. 12C is a plan view that corresponds to Fig. 12B.
[Fig. 13A] Fig. 13A is a diagram for describing the method of manufacturing the semiconductor package in Fig. 1.
[Fig. 13B] Fig. 13B is a plan view that corresponds to Fig. 13A.
[Fig. 14] Fig. 14 is a diagram for describing the method of manufacturing the semiconductor package in Fig. 1.
[Fig. 15A] Fig. 15A is a diagram for describing the method of manufacturing the semiconductor package in Fig. 1.
[Fig. 15B] Fig. 15B is a plan view that corresponds to Fig. 15A.
[Fig. 16A] Fig. 16A is a diagram for describing the method of manufacturing the semiconductor package in Fig. 1.
[Fig. 16B] Fig. 16B is a diagram for describing the method of manufacturing the semiconductor package in Fig. 1.
[Fig. 17] Fig. 17 illustrates a modification to the redistribution layer chip in Fig. 5.
[Fig. 18] Fig. 18 illustrates a modification to the semiconductor package in Fig. 1.
[Fig. 19] Fig. 19 illustrates a modification to the semiconductor package in Fig. 1.
[Fig. 20] Fig. 20 is a sectional view of the semiconductor package in Fig. 19 taken along line C-C.
[Fig. 21] Fig. 21 illustrates a modification to the semiconductor package in Fig. 1.
[Fig. 22] Fig. 22 is a sectional view of the semiconductor package in Fig. 21 taken along line D-D.
[Fig. 23] Fig. 23 illustrates a modification to the semiconductor package in Fig. 1.
[Fig. 24] Fig. 24 illustrates a modification to a semiconductor package intermediate in Fig. 13A.
[Fig. 25(A)] Fig. 25(A) is a diagram for describing the method of manufacturing the semiconductor package intermediate in Fig. 24.
[Fig. 25(B)] Fig. 25(B) is a diagram for describing the method of manufacturing the semiconductor package intermediate in Fig. 24.
[Fig. 25(C)] Fig. 25(C) is a diagram for describing the method of manufacturing the semiconductor package intermediate in Fig. 24.
[Fig. 25(D)] Fig. 25(D) is a diagram for describing the method of manufacturing the semiconductor package intermediate in Fig. 24.
[Fig. 26A(A)] Fig. 26A(A) is a diagram for describing the method of manufacturing the redistribution layer chip that is included in the semiconductor package intermediate in Fig. 24.

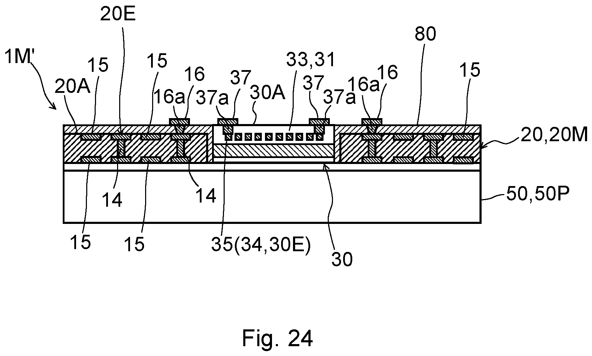

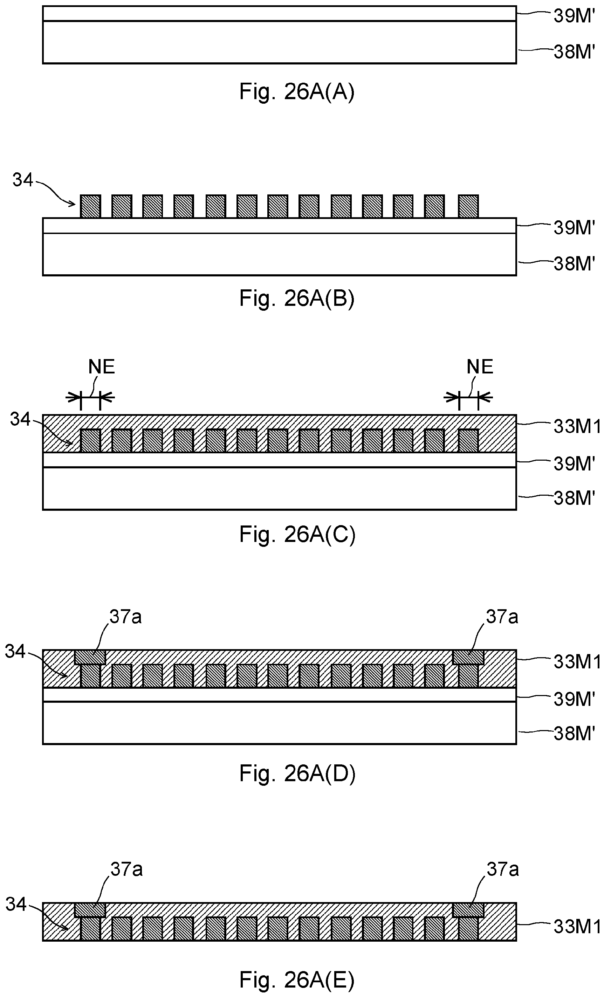

[Fig. 26A(B)] Fig. 26A(B) is a diagram for describing the method of manufacturing the redistribution layer chip that is included in the semiconductor package intermediate in Fig. 24.
[Fig. 26A(C)] Fig. 26A(C) is a diagram for describing the method of manufacturing the redistribution layer chip that is included in the semiconductor package intermediate in Fig. 24.
[Fig. 26A(D)] Fig. 26A(D) is a diagram for describing the method of manufacturing the redistribution layer chip that is included in the semiconductor package intermediate in Fig. 24.
[Fig. 26A(E)] Fig. 26A(E) is a diagram for describing the method of manufacturing the redistribution layer chip that is included in the semiconductor package intermediate in Fig. 24.

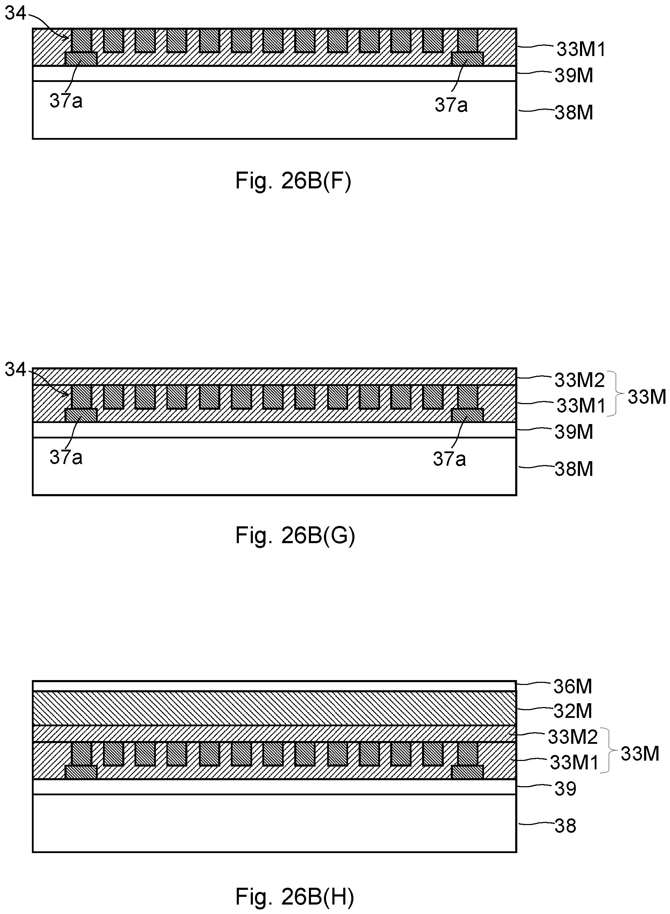

[Fig. 26B(F)] Fig. 26B(F) illustrates processes that are performed after processes in the manufacturing method in Fig. 26A.
[Fig. 26B(G)] Fig. 26B(G) illustrates processes that are performed after processes in the manufacturing method in Fig. 26A.
[Fig. 26B(H)] Fig. 26B(H) illustrates processes that are performed after processes in the manufacturing method in Fig. 26A.

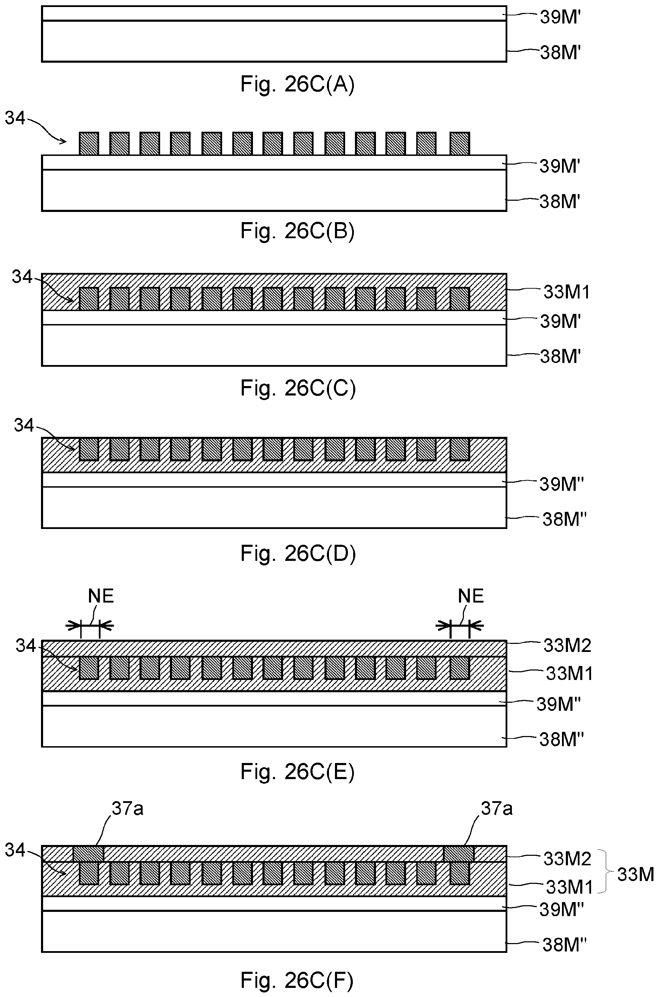

[Fig. 26C(A)] Fig. 26C(A) is a diagram for describing another method of manufacturing the redistribution layer chip that is included in the semiconductor package intermediate in Fig. 24.
[Fig. 26C(B)] Fig. 26C(B) is a diagram for describing another method of manufacturing the redistribution layer chip that is included in the semiconductor package intermediate in Fig. 24.
[Fig. 26C(C)] Fig. 26C(C) is a diagram for describing another method of manufacturing the redistribution layer chip that is included in the semiconductor package intermediate in Fig. 24.
[Fig. 26C(D)] Fig. 26C(D) is a diagram for describing another method of manufacturing the redistribution layer chip that is included in the semiconductor package intermediate in Fig. 24.
[Fig. 26C(E)] Fig. 26C(E) is a diagram for describing another method of manufacturing the redistribution layer chip that is included in the semiconductor package intermediate in Fig. 24.
[Fig. 26C(F)] Fig. 26C(F) is a diagram for describing another method of manufacturing the redistribution layer chip that is included in the semiconductor package intermediate in Fig. 24.

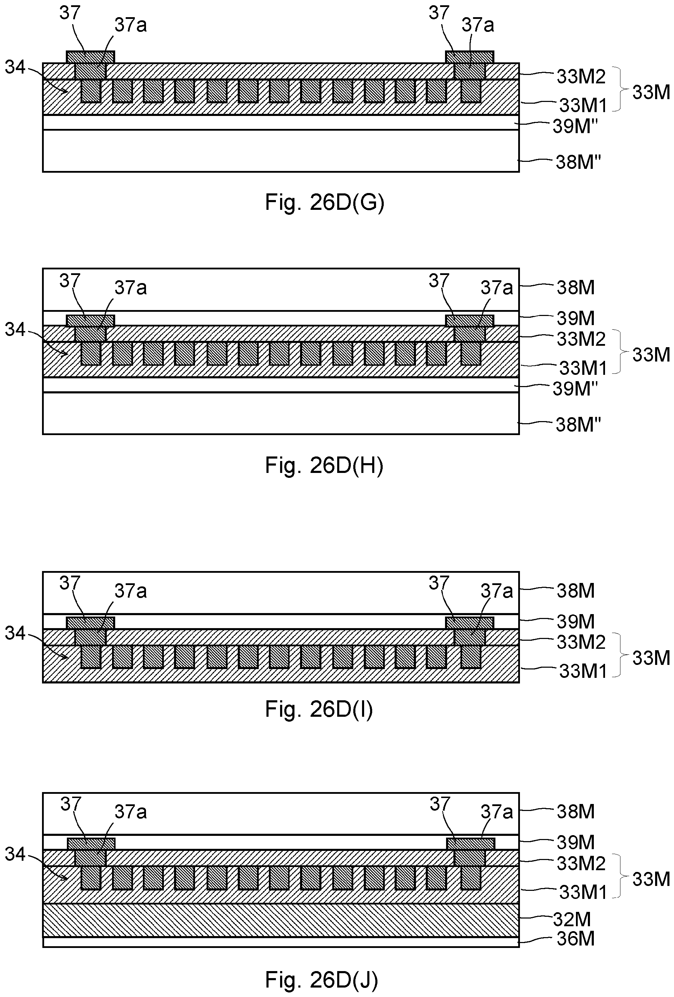

[Fig. 26D(G)] Fig. 26D(G) illustrates processes that are performed after processes in the manufacturing method in Fig. 26C.
[Fig. 26D(H)] Fig. 26D(H) illustrates processes that are performed after processes in the manufacturing method in Fig. 26C.
[Fig. 26D(I)] Fig. 26D(I) illustrates processes that are performed after processes in the manufacturing method in Fig. 26C.
[Fig. 26D(J)] Fig. 26D(J) illustrates processes that are performed after processes in the manufacturing method in Fig. 26C.

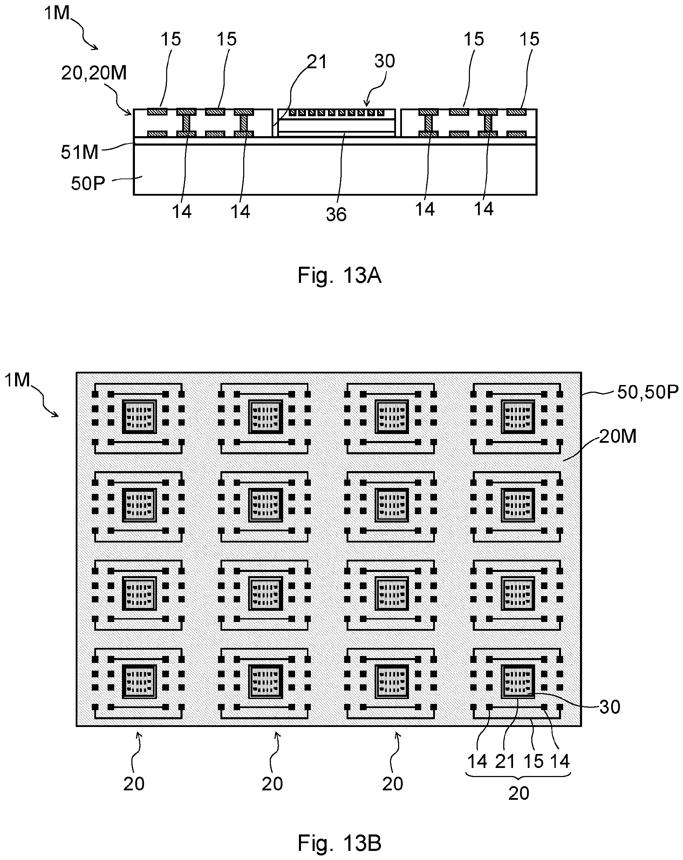

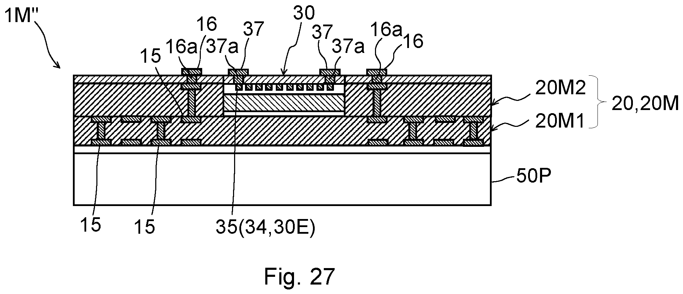

[Fig. 27] Fig. 27 illustrates another modification to the semiconductor package intermediate in Fig. 13A.

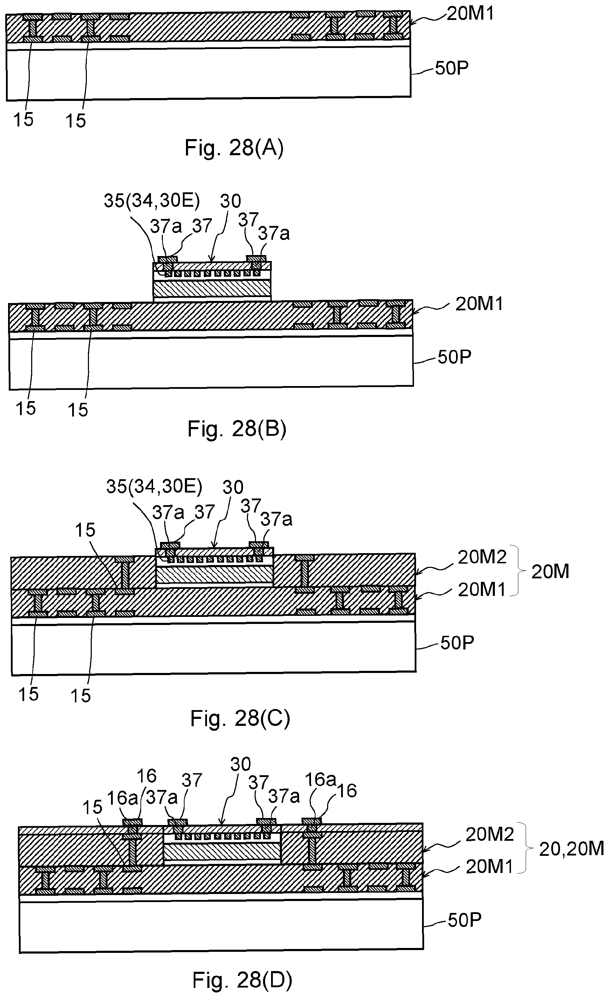

[Fig. 28(A)] Fig. 28(A) is a diagram for describing the method of manufacturing the semiconductor package intermediate in Fig. 27.
[Fig. 28(B)] Fig. 28(B) is a diagram for describing the method of manufacturing the semiconductor package intermediate in Fig. 27.
[Fig. 28(C)] Fig. 28(C) is a diagram for describing the method of manufacturing the semiconductor package intermediate in Fig. 27.
[Fig. 28(D)] Fig. 28(D) is a diagram for describing the method of manufacturing the semiconductor package intermediate in Fig. 27.

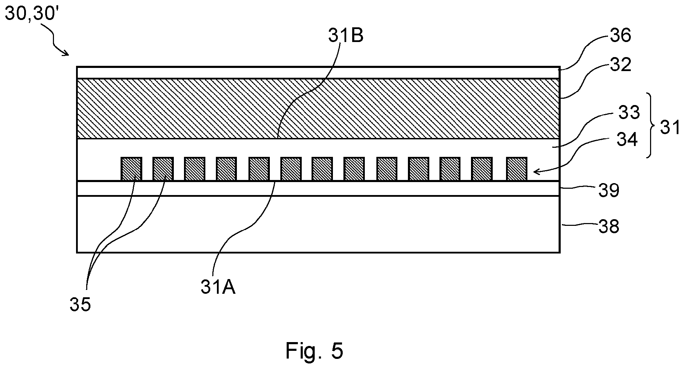

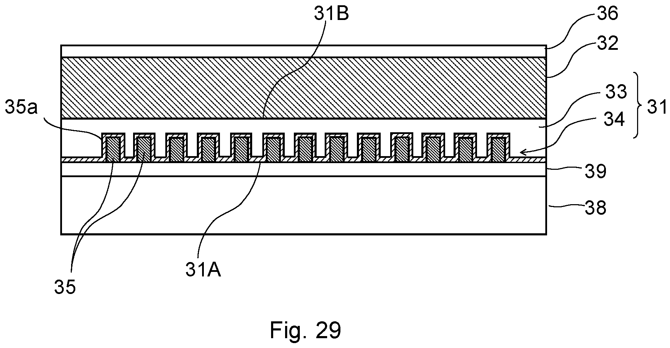

[Fig. 29] Fig. 29 illustrates a modification to the redistribution layer chip in Fig. 5.

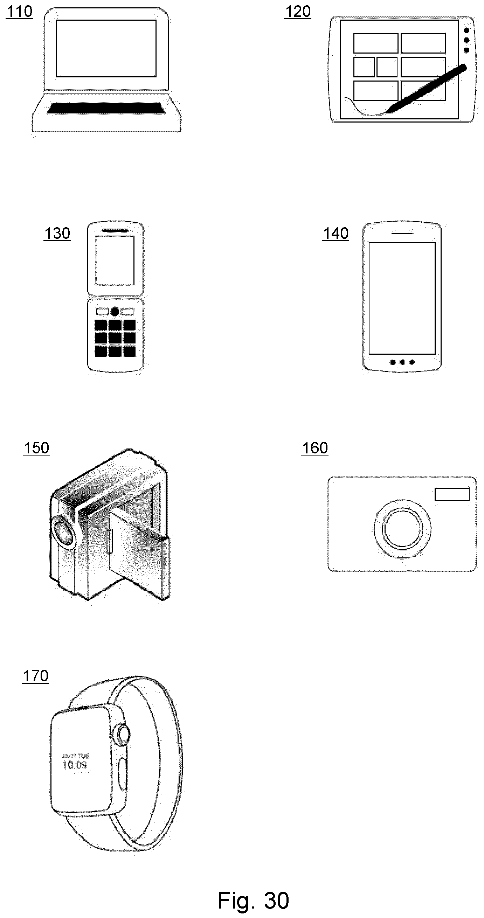

[Fig. 30] Fig. 30 illustrates an example of a product to which a semiconductor package is mounted.

### Description of Embodiments

A structure of a semiconductor package, a method of manufacturing the semiconductor package, and the like will now be described in detail with reference to the drawings. An embodiment described below is an example of an embodiment of the present disclosure, and the present disclosure is not interpreted so as to be limited to the embodiment. In the present specification, words such as a "substrate", a "base material", a "sheet", and a "film" are not distinguished from each other only based on different names. For example, the "substrate" has a concept that also involves a member that can be called a sheet or a film. A normal direction that is used for a plate member means a normal direction to a surface of the member. Words such as "parallel" and "perpendicular" and the values of a length and an angle that specify shapes, geometrical conditions, and the degree of these and that are used in the present specification, for example, are not limited by strict meaning but are interpreted to an extent that the same function can be expected.

In the case where multiple candidates of the upper limit and multiple candidates of the lower limit regarding a parameter are taken in the present specification, the numeral range of the parameter may include a combination of any one of the candidates of the upper limit and any one of the candidates of the lower limit. For example, the case of the description that "for example, a parameter B is A1 or more, may be A2 or more, or may be A3 or more. For example, the parameter B is A4 or less, may be A5 or less, or may be A6 or less" is considered. In this case, the numeral range of the parameter B may be A1 or more and A4 or less, may be A1 or more and A5 or less, may be A1 or more and A6 or less, may be A2 or more and A4 or less, may be A2 or more and A5 or less, may be A2 or more and A6 or less, may be A3 or more and A4 or less, may be A3 or more and A5 or less, or may be A3 or more and A6 or less.

In the drawings referred to according to the present embodiment, like portions or portions that have the same function are designated by like reference signs or similar reference signs, and a duplicated description for these is omitted in some cases. For convenience of description, the ratio of dimensions in the drawings differs from an actual ratio, and an illustration of a portion of a component is omitted in the drawings in some cases.

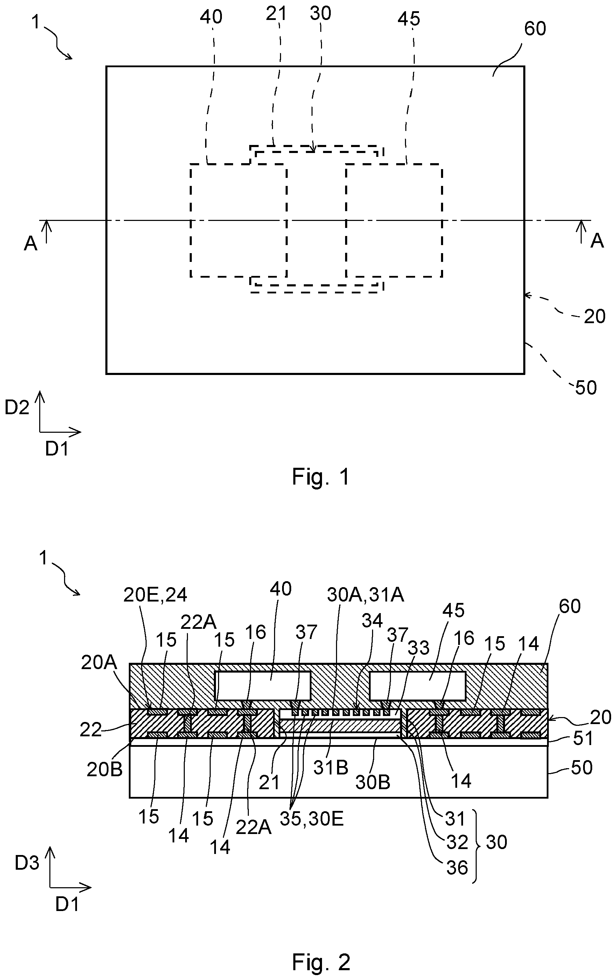

Fig. 1 is a plan view of a semiconductor package 1 according to an embodiment. Fig. 2 is a sectional view of the semiconductor package 1 in Fig. 1 taken along line A-A. The semiconductor package 1 has a first direction D1, a second direction D2, and a third direction D3. The first direction D1 and the second direction D2 are included in a plane direction of the semiconductor package 1. The first direction D1 is perpendicular to the second direction D2. The third direction D3 is the thickness direction of the semiconductor package 1. The third direction D3 is perpendicular to the first direction D1 and the second direction D2.

The semiconductor package 1 includes an interposer 20, a redistribution layer chip 30, a first semiconductor element 40, a second semiconductor element 45, a support carrier 50, and a second mold resin layer 60. The redistribution layer chip 30 includes a redistribution element 31 and a first mold resin layer 32.

The support carrier 50 supports the interposer 20 and the redistribution layer chip 30. The interposer 20 and the redistribution layer chip 30 are adjacent to each other above the support carrier 50 in the plane direction of the semiconductor package 1, or the first direction D1 in this example. The first semiconductor element 40 is stacked and mounted to the interposer 20 and the redistribution layer chip 30 in a direction that intersects with the direction in which the interposer 20 and the redistribution layer chip 30 are adjacent to each other, or the thickness direction of the semiconductor package 1 in this example, that is, the third direction D3. In other words, the first semiconductor element 40 overlaps the interposer 20 and the redistribution layer chip 30 when viewed in the third direction D3 in plan view. The second semiconductor element 45 is stacked and mounted to the interposer 20 and the redistribution layer chip 30 in the direction that intersects with the direction in which the interposer 20 and the redistribution layer chip 30 are adjacent to each other, or the thickness direction of the semiconductor package 1 in this example, that is, the third direction D3. In other words, the second semiconductor element 45 overlaps the interposer 20 and the redistribution layer chip 30 when viewed in the third direction D3 in plan view. The second mold resin layer 60 covers the interposer 20, the redistribution layer chip 30, the first semiconductor element 40, and the second semiconductor element 45.

The interposer 20 illustrated includes a through-portion 21 that has a hole extending through the interposer 20 in the thickness direction, which is an example. The redistribution layer chip 30 is placed at the through-portion 21. Consequently, the redistribution layer chip 30 is adjacent to the interposer 20. The interposer 20 and the redistribution layer chip 30 extend in the first direction D1 and the second direction D2. The shape of the interposer 20 is not particularly limited. For example, the interposer 20 may have a rectangular plate shape, and the redistribution layer chip 30 may be adjacent to the interposer 20 in the first direction D1 or the second direction D2.

As illustrated in Fig. 1, the redistribution layer chip 30 that is placed at the through-portion 21 may have a distance from the interposer 20 over the entire circumference of the redistribution layer chip 30. For example, the distance between the redistribution layer chip 30 and the interposer 20 is 0.03 mm or more, may be 0.05 mm or more, or may be 0.1 mm or more. For example, the distance between the redistribution layer chip 30 and the interposer 20 is 3.0 mm or less, may be 1.0 mm or less, or may be 0.5 mm or less. The distance between the redistribution layer chip 30 and the interposer 20 described herein is the minimum distance between a point on the outer circumference of the redistribution layer chip 30 and the through-portion 21.

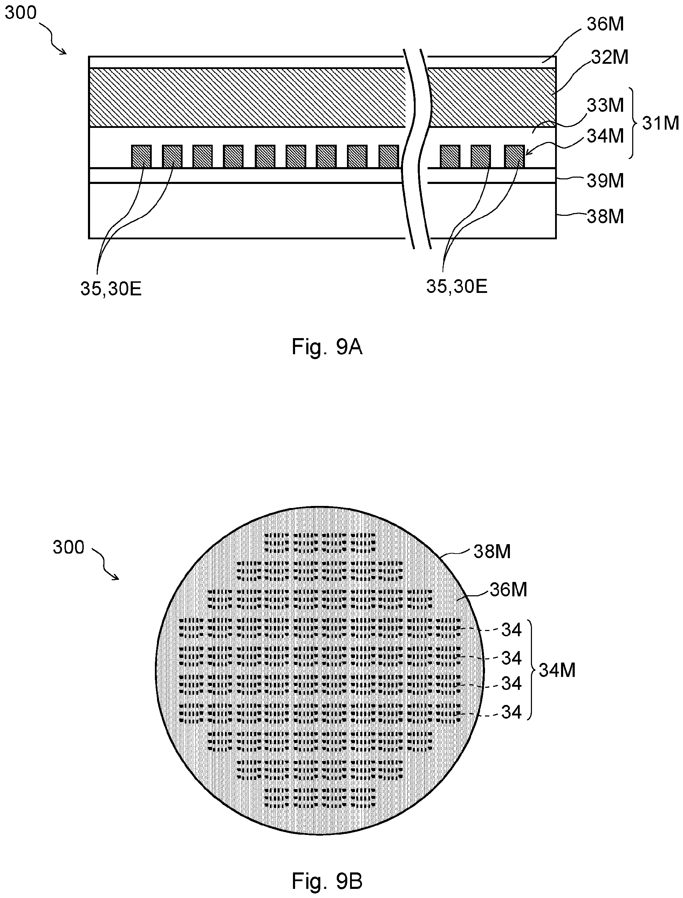

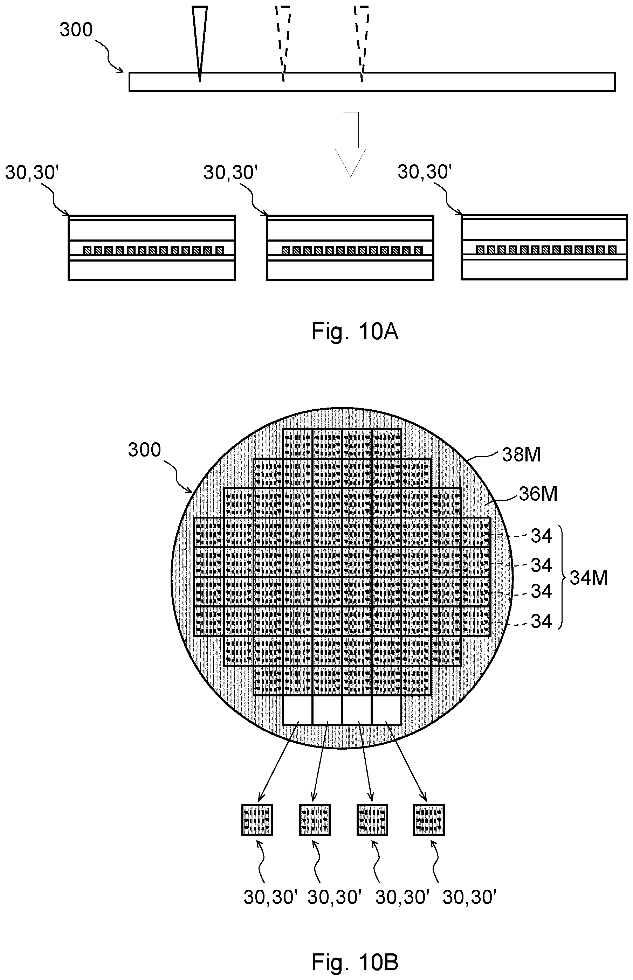

The shapes of the redistribution layer chip 30 and the through-portion 21 are not particularly limited. As illustrated in Fig. 1, the redistribution layer chip 30 and the through-portion 21 may have a rectangular shape in plan view. The shape of the through-portion 21 in plan view may be larger than the redistribution layer chip 30 and may be similar to that of the redistribution layer chip 30. The redistribution layer chip 30 is one of multiple redistribution layer chips 30 that are cut out of a redistribution layer chip intermediate 300 (see Figs. 9 and Figs. 10) described later. The shape of the redistribution layer chip 30 is preferably a rectangular shape in consideration of ease of processing.

As illustrated in Fig. 1, the first semiconductor element 40 overlaps the interposer 20 and the redistribution layer chip 30 in plan view, in other words, when viewed in the third direction D3. Specifically, the first semiconductor element 40 overlaps the interposer 20 and the redistribution layer chip 30 and is mounted to the interposer 20 and the redistribution layer chip 30. The first semiconductor element 40 is electrically connected to both of the interposer 20 and the redistribution layer chip 30. Specifically, referring to Fig. 2, the redistribution layer chip 30 includes a first conductive portion 30E that includes first wirings 35 that are electrically connected to the first semiconductor element 40. The first conductive portion 30E is included in a first redistribution layer 34 in the redistribution element 31. The interposer 20 includes a second conductive portion 20E that includes multiple through-electrodes 14 and second wirings 15. The second conductive portion 20E is included in a second redistribution layer 24 that is included in the interposer 20. In an illustrated example, one or more of the multiple through-electrodes 14 in the second conductive portion 20E are electrically connected to the first semiconductor element 40.

The second semiconductor element 45 overlaps the interposer 20 and the redistribution layer chip 30 at a position that differs from that of the first semiconductor element 40 in plan view, in other words, when viewed in the third direction D3. Specifically, the second semiconductor element 45 overlaps the interposer 20 and the redistribution layer chip 30 and is mounted in this state. The second semiconductor element 45 is electrically connected to both of the interposer 20 and the redistribution layer chip 30. Specifically, the first conductive portion 30E in the redistribution layer chip 30 includes the first wirings 35 that are electrically connected to the second semiconductor element 45. The second semiconductor element 45 is electrically connected to one or more of the multiple through-electrodes 14 of the second conductive portion 20E in the interposer 20. The first wirings 35 may electrically connect the first semiconductor element 40 and the second semiconductor element 45 to each other.

The interposer 20 has a first surface 20A and a second surface 20B. The second surface 20B is opposite the first surface 20A. The through-electrodes 14 are located in through-holes 22A that extend from the first surface 20A to the second surface 20B. Specifically, the interposer 20 includes an interposer insulating layer 22 in which the second conductive portion 20E (the second redistribution layer 24) that includes the through-electrodes 14 and the second wirings 15 is provided. The interposer insulating layer 22 includes the multiple through-holes 22A that extend in the thickness direction. The through-electrodes 14 are located in the through-holes 22A. The first semiconductor element 40 is electrically connected to the through-electrodes 14 in the second conductive portion 20E but may be electrically connected to, for example, an electrode that extends from the first surface 20A and that is located in a hole having a bottom. The second wirings 15 are imbedded in the interposer insulating layer 22. In other words, the second wirings 15 are covered by the interposer insulating layer 22. The second wirings 15 illustrated are embedded in the interposer insulating layer 22, and part of the second wirings 15 is exposed to the outside from the interposer insulating layer 22. The second wirings 15 may be connected to the semiconductor elements 40 and 45 at portions exposed to the outside from the interposer insulating layer 22. The second wirings 15 may be provided on the surface of the interposer insulating layer 22.

The first surface 20A includes a surface of the interposer insulating layer 22 at one side in the thickness direction, surfaces of the through-electrodes 14 that are exposed from the through-holes 22A at one side in the thickness direction of the interposer insulating layer 22, and surfaces of the second wirings 15 that are exposed from the interposer insulating layer 22 at one side in the thickness direction of the interposer insulating layer 22. The second surface 20B includes a surface of the interposer insulating layer 22 at the other side in the thickness direction, surfaces of the through-electrodes 14 that are exposed from the through-holes 22A at the other side in the thickness direction of the interposer insulating layer 22, and surfaces of the second wirings 15 that are exposed from the interposer insulating layer 22 at the other side in the thickness direction of the interposer insulating layer 22.

The through-portion 21 is formed in the interposer insulating layer 22. The multiple through-holes 22A are formed at portions around the through-portion 21 in the interposer insulating layer 22. Accordingly, the multiple through-electrodes 14 are located around the through-portion 21 in the interposer insulating layer 22. Similarly, the second wirings 15 are located around the through-portion 21 in the interposer insulating layer 22. The through-electrodes 14 and the second wirings 15 may be electrically connected.

The redistribution layer chip 30 has a first surface 30A and a second surface 30B. The second surface 30B is opposite the first surface 30A. The first surface 30A of the redistribution layer chip 30 faces in the same direction as the first surface 20A of the interposer 20. The second surface 30B of the redistribution layer chip 30 faces in the same direction as the second surface 20B of the interposer 20. The first semiconductor element 40 and the second semiconductor element 45 overlap the first surface 20A of the interposer 20 and the first surface 30A of the redistribution layer chip 30. The first semiconductor element 40 and the second semiconductor element 45 are mounted to the first surface 20A of the interposer 20 and the first surface 30A of the redistribution layer chip 30. Portions of the first wirings 35 in the first conductive portion 30E described above are located at the first surface 30A. The portions of the first wirings 35 that are located at the first surface 30A are connected to the semiconductor elements 40 and 45.

The support carrier 50 faces the first semiconductor element 40 and the second semiconductor element 45 with the interposer 20 and the redistribution layer chip 30 interposed therebetween. The support carrier 50 supports the interposer 20 and the redistribution layer chip 30. The second surface 20B of the interposer 20 faces the support carrier 50. Specifically, the interposer 20 is formed above the support carrier 50 such that the second surface 20B is in contact with a release layer 51. The second surface 30B is joined to the support carrier 50 with the release layer 51 interposed therebetween, and consequently, the redistribution layer chip 30 is mounted to the support carrier 50. The support carrier 50 is separable from the interposer 20 and the redistribution layer chip 30. The support carrier 50 is separated from the interposer 20 and the redistribution layer chip 30 together with the release layer 51.

The second mold resin layer 60 covers the interposer 20 and the redistribution layer chip 30 and is mounted to the interposer 20 and the redistribution layer chip 30. Specifically, the second mold resin layer 60 is joined to the first surface 20A of the interposer 20 and the first surface 30A of the redistribution layer chip 30. The second mold resin layer 60 is joined to the first semiconductor element 40 and the second semiconductor element 45 and holds the first semiconductor element 40 and the second semiconductor element 45. This enables the interposer 20, the redistribution layer chip 30, the first semiconductor element 40, and the second semiconductor element 45 that are connected as a single body to be maintained even in the case where the support carrier 50 is separated from the interposer 20 and the redistribution layer chip 30.

Components of the semiconductor package 1 will be described in detail.

The interposer 20 includes the interposer insulating layer 22 and the second redistribution layer 24. The second redistribution layer 24 includes the second conductive portion 20E, and the second conductive portion 20E includes the through-electrodes 14 and the second wirings 15. The through-electrodes 14 and the second wirings 15 are conductive. As illustrated in Fig. 2, the interposer 20 may include pads 16 that are provided at the first surface 20A. The interposer 20 may include an insulating layer and a wiring provided on the first surface 20A although not illustrated.

The interposer insulating layer 22 may be composed of insulating resin. Examples of the insulating resin of which the interposer insulating layer 22 is composed may include polyimide, epoxy resin, acryl resin, or a combination of two or more of these. According to the present embodiment, the interposer insulating layer 22 is composed of polyimide. The interposer insulating layer 22 may be a glass substrate, a quartz substrate, a sapphire substrate, a silicon substrate, a silicon carbide substrate, an alumina (Al2O3) substrate, an aluminum nitride (AIN) substrate, a zirconium oxide (ZrO2) substrate, a lithium niobate substrate, a tantalum niobate substrate, or a multiplayer substrate of these. The interposer insulating layer 22 may include a portion of a substrate composed of a conductive material such as an aluminum substrate, or a stainless steel substrate. For example, the thickness of the interposer insulating layer 22 is 0.01 mm or more, may be 0.1 mm or more, or may be 0.2 mm or more. For example, the thickness of the interposer insulating layer 22 is 2.0 mm or less, may be 1.5 mm or less, or may be 1.0 mm or less.

The through-electrodes 14 extend from one surface of the interposer insulating layer 22 to the other surface in the thickness direction in the through-holes 22A of the interposer insulating layer 22. The through-electrodes 14 may be located over the entire region of the through-holes 22A. That is, the through-electrodes 14 may be so-called filled-vias that fill the through-holes 22A. The through-electrodes 14 may or may not fill the through-holes 22A.

The through-electrodes 14 may include multiple layers. For example, the through-electrodes 14 may include first layers that are located on side surfaces of the through-holes 22A and second layers that are located on the first layers. The second layers may extend to the centers of the through-holes 22A in plan view.

For example, the first layers are formed on the side surfaces of the through-holes 22A by using a physical film formation method such as a spattering method or a vapor deposition method. For example, the thicknesses of the first layers are 0.05 µm or more. For example, the thicknesses of the first layers are 1.0 µm or less. Other layers may be provided between the first layers and the side surfaces of the through-holes 22A. The materials of the first layers can be metal such as titanium, chromium, nickel, or copper, an alloy of these, or a stack of these.

The second layers may contain copper as a main component. For example, the second layers may contain copper in an amount of 80% or more by mass. The second layers may contain metal such as gold, silver, platinum, rhodium, tin, aluminum, nickel, or chromium or an alloy of these. For example, the second layers are formed on the first layers by using an electroplating method.

The second wirings 15 include conductive layers. Examples of the materials of the second wirings 15 can include the materials described for the through-electrodes 14. For example, the thicknesses of the second wirings 15 are 0.5 µm or more or may be 1.0 µm or more. For example, the thicknesses of the second wirings 15 are 10.0 µm or less or may be 5.0 µm or less. For example, the line widths of the second wirings 15 are 5 µm or more or may be 10 µm or more. For example, the line widths of the second wirings 15 are 30 µm or less or may be 20 µm or less.

The pads 16 contain conductive layers. The pads 16 may be located above the through-electrodes 14 at the first surface 20A. Examples of the materials of the pads 16 can include the materials described for the through-electrodes 14. For example, the thicknesses of the pads 16 are 0.5 µm or more or may be 1.0 µm or more. For example, the thicknesses of the pads 16 are 10.0 µm or less or may be 5.0 µm or less.

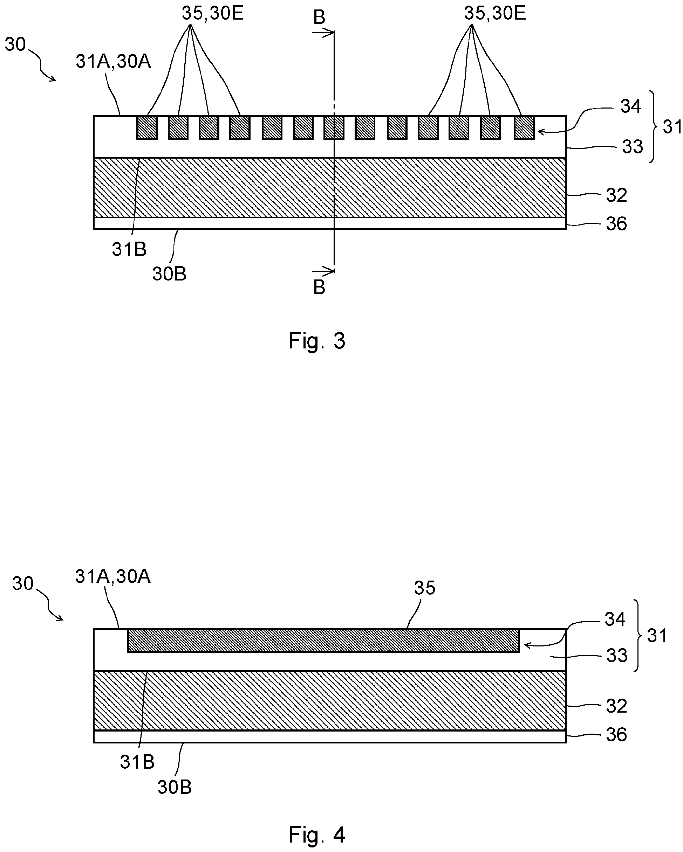

Fig. 3 is an enlarged sectional view of the redistribution layer chip 30. The redistribution layer chip 30 includes the redistribution element 31, the first mold resin layer 32, and an adhesive layer 36. The redistribution element 31 includes an insulating layer 33 that has insulation properties and the first redistribution layer 34 that is embedded in the insulating layer 33. In other words, the redistribution element 31 includes the insulating layer 33 that has the insulation properties and the first redistribution layer 34 that is covered by the insulating layer 33. According to the present disclosure, the redistribution layer chip 30 is used for redistribution and is accordingly referred to as the "redistribution layer" chip. The redistribution layer chip 30 may be simply referred to as a wiring layer chip, and the redistribution element 31 may be simply referred to as a wiring element.

The redistribution element 31 has a first surface 31A and a second surface 31B opposite the first surface 31A. In the state of Fig. 2, the first surface 31A forms a surface that the first semiconductor element 40 and the second semiconductor element 45 overlap. That is, in the state of Fig. 2, the first surface 31A forms the first surface 30A of the redistribution layer chip 30. The first mold resin layer 32 is mounted to the second surface 31B. The adhesive layer 36 is mounted to a surface opposite the surface of the first mold resin layer 32 that is mounted to the second surface 31B of the redistribution element 31. The adhesive layer 36 forms the second surface 30B of the redistribution layer chip 30.

As illustrated in Fig. 2, the redistribution layer chip 30 may include pads 37 that are provided at the first surface 31A. The first redistribution layer 34 includes the first conductive portion 30E that includes the first wirings 35 described above. In an illustrated example, at least the portions of the first wirings 35 in the first conductive portion 30E are located at the first surface 31A of the redistribution element 31. In other words, at least the portions of the first wirings 35 form the first surface 31A. At least the portions of the first wirings 35 in the first conductive portion 30E that are located at the first surface 31A are connected to the semiconductor elements 40 and 45.

Examples of the insulating layer 33 may include polyimide, epoxy resin, acryl resin, or a combination of two or more of these. For example, the thickness of the insulating layer 33 is 3 µm or more or may be 5 µm or more. For example, the thickness of the insulating layer 33 is 20 µm or less or may be 10 µm or less.

Examples of the material of the first conductive portion 30E that includes the first wirings 35 can include the materials described for the through-electrodes 14. For example, the thicknesses of the first wirings 35 are 0.5 µm or more or may be 1 µm or more. For example, the thicknesses of the first wirings 35 are 5 µm or less or may be 3 µm or less. For example, the line widths of the first wirings 35 are 10 µm or less. For example, the line widths of the first wirings 35 may be 5 µm or less, may be 3 µm or less, or may be 2 µm or less. The line widths of the first wirings 35 may be less than the line widths of the second wirings 15 of the interposer 20. For example, the minimum value of the line widths of the first wirings 35 is 1/2 or less, may be 1/5 or less, or may be 1/10 or less of the minimum value of the line widths of the second wirings 15 of the interposer 20. The multiple first wirings 35 may be provided in a line-and-space pattern. In this case, the line widths of the first wirings 35 and the distances (spaces) between the first wirings 35 adjacent to each other may be equal to each other or may differ from each other. For example, the distances between the first wirings 35 adjacent to each other may be 1 µm or more and 5 µm or less, may be 1 µm or more and 3 µm or less, or may be 1 µm or more and 2 µm or less. For example, the aspect ratios (thicknesses/line widths) of the first wirings 35 may be 1 or more and 4 or less or may be 1 or more and 2.5 or less.

Fig. 4 is a sectional view of the redistribution layer chip 30 in Fig. 3 taken along line B-B. The first wirings 35 linearly extend in the second direction D2. The first redistribution layer 34 includes the multiple first wirings 35, and the multiple first wirings 35 are formed in parallel with each other in the line-and-space pattern. Each first wiring 35 has a section that has a rectangular shape in the direction perpendicular to the longitudinal direction, and only one side of four sides of the rectangular shape is exposed to the outside from the insulating layer 33. The surface of each first wiring 35 that is exposed to the outside from the insulating layer 33 forms the first surface 31A. The pattern in which the first wirings 35 are formed is not particularly limited. The first redistribution layer 34 may include a wiring that is completely embedded in, in other words, covered by the insulating layer 33. The first conductive portion 30E in the first redistribution layer 34 may include a through-electrode. The first conductive portion 30E in the first redistribution layer 34 may include a wiring that is located at the second surface 31B.

The pads 37 include conductive layers. The pads 37 may be located above the first wirings 35 on the first surface 31A. Examples of the materials of the pads 37 can include the materials described for the through-electrodes 14. For example, the thicknesses of the pads 37 are 0.5 µm or more or may be 1.0 µm or more. For example, the thicknesses of the pads 37 are 10.0 µm or less or may be 5.0 µm or less.

The first mold resin layer 32 contains resin. Examples of the resin that is contained in the first mold resin layer 32 may include polyimide, epoxy resin, acryl, bismaleimide, polybenzoxazole, benzocyclobutene, or a combination of two or more of these. The first mold resin layer 32 is provided to inhibit the redistribution element 31 from deforming. The first mold resin layer 32 may have at least any one of characteristics (1) to (4) described below to preferably inhibit the redistribution element 31 from deforming.

(1) The thermal expansion coefFicient, that is, the linear expansion coefficient of the first mold resin layer 32 is lower than the thermal expansion coefFicient, that is, the linear expansion coefficient of the insulating layer 33.
(2) The Young's modulus of the first mold resin layer 32 is more than the Young's modulus of the insulating layer 33.
(3) The bending stiffness of the first mold resin layer 32 is more than the bending stiffness of the insulating layer 33.
(4) The thickness of the first mold resin layer 32 is more than the thickness of the insulating layer 33.

The thermal expansion coefficient of the first mold resin layer 32 and the thermal expansion coefficient of the insulating layer 33 are measured in accordance with JISK7197:2012. That is, in the present specification, the thermal expansion coefficient means the linear expansion coefficient that is measured in accordance with JISK7197:2012. The Young's modulus of the first mold resin layer 32 and the Young's modulus of the insulating layer 33 are specified in a manner in which the mechanical characteristics of the first mold resin layer 32 and the insulating layer 33 are measured by using a nanoindentation method. The bending stiffness of the first mold resin layer 32 and the bending stiffness of the insulating layer 33 are calculated in a manner in which the Young's moduli of the first mold resin layer 32 and the insulating layer 33 are specified by using the nanoindentation method described above, and the sectional shapes of the first mold resin layer 32 and the insulating layer 33 are specified.

The Young's moduli are measured by using the nanoindentation method described above through procedures described below.

The first mold resin layer 32 and the insulating layer 33 are placed on a measurement device "TI950 Tribolndenter" made by BRUKER. In the case where the redistribution layer chip 30 is incorporated into the semiconductor package 1 at this time, the redistribution layer chip 30 is cut and is placed on the measurement device described above. In the case before the redistribution layer chip 30 is incorporated into the semiconductor package 1, the redistribution layer chip 30 before incorporation is placed on the measurement device described above.

The nanoindentation method starts for measurement at a side surface of the first mold resin layer 32 or the insulating layer 33. At this time, an indenter is pressed against the side surface of the first mold resin layer 32 or the insulating layer 33 at any intermediate position in the thickness direction for 10 seconds up to a depth of 100 nm in a plane direction, is held in this state for 5 seconds, and is subsequently returned to a depth of 0 nm for 10 seconds. The first mold resin layer 32 and the insulating layer 33 are pressed separately. Consequently, the Young's modulus of each target to be measured is calculated. The indenter described above is a diamond indenter (Berkovich indenter TI-0039) at a face angle of 142.3°.

The thermal expansion coefficient (the linear expansion coefFicient) of the first mold resin layer 32 may be 2 ppm/°C or more and 12 ppm/°C or less or may be 5 ppm/°C or more and 9 ppm/°C or less. The linear expansion coefficient of the first mold resin layer 32 may be lower than the linear expansion coefficient of the insulating layer 33 in the perspective that the redistribution element 31 is inhibited from deforming as described above. Examples of the insulating layer 33 may include polyimide, epoxy resin, acryl resin, or a combination of two or more of these as described above. Examples of the resin that is contained in the first mold resin layer 32 may include polyimide, epoxy resin, acryl resin, bismaleimide, polybenzoxazole, benzocyclobutene, or a combination of two or more of these. A relationship of the linear expansion coefficient of polyimide > the linear expansion coefficient of acryl > the linear expansion coefficient of epoxy is typically satisfied. Accordingly, in the case where the linear expansion coefficient of the first mold resin layer 32 is lower than the linear expansion coefficient of the insulating layer 33, for example, in the case where the first mold resin layer 32 contains polyimide, the insulating layer 33 preferably contains polyimide. The amount of polyimide molecules that are contained in the first mold resin layer 32 may be larger than the amount of polyimide molecules that are contained in the insulating layer 33 in order to reduce the linear expansion coefficient of the first mold resin layer 32 to a coefficient lower than the linear expansion coefficient of the insulating layer 33. As the amount of the molecules increases, the movement of the molecules is restricted, and the linear expansion coefficient tends to decrease. In the case where the first mold resin layer 32 and the insulating layer 33 contain the same resin, the amount of resin molecules that are contained in the first mold resin layer 32 may be larger than the amount of resin molecules that are contained in the insulating layer 33 when the linear expansion coefficient of the first mold resin layer 32 is reduced to the coefficient lower than the linear expansion coefficient of the insulating layer 33. In the case where the first mold resin layer 32 and the insulating layer 33 contain the same resin, the adhesion strength between the first mold resin layer 32 and the insulating layer 33 can be improved.

The Young's modulus of the first mold resin layer 32 may be 12 GPa or more and 30 GPa or less or may be 18 GPa or more and 22 GPa or less. The Young's modulus of the first mold resin layer 32 may be more than the Young's modulus of the insulating layer 33 in the perspective that the redistribution element 31 is inhibited from deforming as described above. A relationship of the Young's modulus of polyimide > the Young's modulus of acryl > the Young's modulus of epoxy is typically satisfied. Accordingly, in the case where the linear expansion coefficient of the first mold resin layer 32 is reduced to the coefficient lower than the linear expansion coefficient of the insulating layer 33, for example, in the case where the first mold resin layer 32 contains polyimide, the insulating layer 33 preferably contains polyimide. The amount of polyimide molecules that are contained in the first mold resin layer 32 may be larger than the amount of polyimide molecules that are contained in the insulating layer 33 in order that the Young's modulus of the first mold resin layer 32 is more than the Young's modulus of the insulating layer 33. In the case where the amount of the molecules is not adjusted, and the first mold resin layer 32 and the insulating layer 33 contain the same resin, the thickness of the first mold resin layer 32 is more than the insulating layer 33, and consequently, the bending stiffness of the first mold resin layer 32 can be more than the bending stiffness of the insulating layer 33. The first mold resin layer 32 may contain a filler that is dispersed in resin such as epoxy resin. In the case where the filler is dispersed in resin, for example, the heat dissipation of heat generated in the first wirings 35 can be improved. An example of the filler may be particles such as silica or alumina particles. The filler may be silicon oxide particles or silicon nitride particles. The silicon oxide or the silicon nitride may contain fluorine or nitrogen. The filler may be carbon black particles.

In the case where the physical properties of the redistribution layer chip 30 and the physical properties of the interposer 20 are similar to each other, the semiconductor package 1 is inhibited from deforming due to differences in the physical properties of these, flatness is easily maintained, and the size of the semiconductor package 1 is easily increased. In this perspective, the first mold resin layer 32 and the insulating layer 33 in the redistribution layer chip 30 and the interposer insulating layer 22 in the interposer 20 may contain the same resin.

In the case where the first mold resin layer 32 contains the filler, the thermal conductivity of the filler is preferably more than the thermal conductivity of the resin in which the filler is dispersed in the perspective of an improvement in the heat dissipation. The filler may be composed of an inorganic material. The color of the filler may be black. In the case where the color of the first mold resin layer 32 is black because of the black filler, for example, light can be inhibited from passing through the redistribution layer chip.

For example, the thickness of the first mold resin layer 32 is 5 µm or more or may be 10 µm or more. For example, the thickness of the first mold resin layer 32 is 50 µm or less or may be 20 µm or less. The first mold resin layer 32 may have a through-hole for providing a through-electrode.

The redistribution layer chip 30 is mounted to the support carrier 50 with the first mold resin layer 32 connected to the support carrier 50. Specifically, the first mold resin layer 32 is connected to the support carrier 50 with the adhesive layer 36 and the release layer 51 interposed therebetween, and the adhesive layer 36 is joined to the release layer 51 in this state. Consequently, the redistribution layer chip 30 is mounted to the support carrier 50. The adhesive layer 36 has heat-sensitive adhesiveness, or photosensitive adhesiveness, or pressure-sensitive adhesiveness. The adhesive layer 36 may be composed of thermoplastic polyimide, which is a material that has the heat-sensitive adhesiveness. As long as the first mold resin layer 32 and the support carrier 50 are joined, the adhesive layer 36 may not be provided. A NCF (Non Conductive Film) or a NCP (Non Conductive Paste) for mounting a semiconductor may be used as the adhesive layer 36. In the case where the NCF or the NCP is used as the adhesive layer 36, the adhesive layer 36 is heated and is subsequently cooled, and consequently, the redistribution layer chip 30 and the support carrier 50 can be stuck to each other by using the NCF or the NCP.

For example, the thickness of the adhesive layer 36 is 5 µm or more or may be 10 µm or more. For example, the thickness of the adhesive layer 36 is 100 µm or less or may be 30 µm or less.

Fig. 5 is a sectional view of the redistribution layer chip 30 before the redistribution layer chip 30 is incorporated as a portion of the semiconductor package 1. The redistribution layer chip 30 before incorporation (referred to below as a pre-incorporation redistribution layer chip 30' in some cases) illustrated in Fig. 5 may include a chip carrier 38 in contact with the first surface 31A of the redistribution element 31. The chip carrier 38 may be mounted to the first surface 31A with a release layer 39 interposed therebetween. As for the pre-incorporation redistribution layer chip 30' before incorporation as the portion of the semiconductor package 1, the first wirings 35 that are located at the first surface 31A are covered and are protected by the chip carrier 38.

For example, the chip carrier 38 may include a glass substrate, a quartz substrate, a sapphire substrate, a resin substrate, a silicon substrate, a silicon carbide substrate, an alumina (Al2O3) substrate, an aluminum nitride (AIN) substrate, a zirconium oxide (ZrO2) substrate, a lithium niobate substrate, or a tantalum niobate substrate. The resin substrate may contain an organic material. For example, the resin substrate may contain epoxy resin, polyethylene, or polypropylene. The release layer 39 is joined to the first surface 31A of the redistribution element 31 and is joined to the chip carrier 38. The release layer 39 can be separated from the portions of the first wirings 35 that form the first surface 31A and the insulating layer 33 and may be separated, for example, by being heated. In this case, the release layer 39 may contain thermoplastic resin. The release layer may be a polyimide resin release layer that can be separated by using about 355 nm laser light. When the release layer 39 is separated, the chip carrier 38 is also separated. For example, the thickness of the chip carrier 38 is 700 µm or more or may be 1000 µm or more. For example, the thickness of the chip carrier 38 is 2000 µm or less or may be 1200 µm or less. For example, the thickness of the release layer 39 is 0.3 µm or more or may be 1 µm or more. For example, the thickness of the release layer 39 is 30 µm or less or may be 100 µm or less.

In the case where the redistribution layer chip 30 is incorporated as the portion of the semiconductor package 1, the chip carrier 38 and the release layer 39 are removed from the pre-incorporation redistribution layer chip 30'. The redistribution layer chip 30 is joined to the release layer 51 with the adhesive layer 36 interposed therebetween and is consequently mounted to the support carrier 50. For example, in the case where the adhesive layer 36 has the heat-sensitive adhesiveness, the redistribution layer chip 30 is placed with the adhesive layer 36 being in contact with the release layer 51. Subsequently, the adhesive layer 36 may be heated, and consequently, the adhesive layer 36 and the release layer 51 may be joined.

Referring to Fig. 1 and Fig. 2 again, the first semiconductor element 40 includes a transistor composed of a semiconductor such as silicon. Examples of the first semiconductor element 40 include a CPU, a GPU, a FPGA, a sensor, and a memory. The first semiconductor element 40 may be a chiplet in which semiconductor elements such as a CPU, a GPU, a FPGA, a sensor, and a memory are divided for every function. The first semiconductor element 40 may include multiple substrates that are stacked.

The first semiconductor element 40 is electrically connected to the interposer 20 with the pads 16 interposed therebetween. A bump may be provided between the pads 16 of the interposer 20 and the first semiconductor element 40. The first semiconductor element 40 is electrically connected to the first wirings 35 in the first conductive portion 30E of the redistribution layer chip 30 with the pads 37 interposed therebetween. A bump may be provided between the pads 37 of the redistribution layer chip 30 and the first semiconductor element 40.

The second semiconductor element 45 includes a transistor composed of a semiconductor such as silicon. Examples of the second semiconductor element 45 include a CPU, a GPU, a FPGA, a sensor, and a memory. The second semiconductor element 45 may be a chiplet in which semiconductor elements such as a CPU, a GPU, a FPGA, a sensor, and a memory are divided for every function. The second semiconductor element 45 may include multiple substrates that are stacked. The shape, function, and performance of the second semiconductor element 45, for example, may be the same as the shape, function, and performance of the first semiconductor element 40 or may differ therefrom.

The second semiconductor element 45 is electrically connected to the interposer 20 with the pads 16 interposed therebetween. A bump may be provided between the pads 16 of the interposer 20 and the second semiconductor element 45. The second semiconductor element 45 is electrically connected to the first wirings 35 of the redistribution layer chip 30 with the pads 37 interposed therebetween. A bump may be provided between the pads 37 of the redistribution layer chip 30 and the second semiconductor element 45.

The support carrier 50 supports the interposer 20 and the redistribution layer chip 30. The support carrier 50 is separable from the interposer 20 and the redistribution layer chip 30. When the support carrier 50 is separated, the release layer 51 is also separated. In the case where the support carrier 50 and the release layer 51 are separated, the through-electrodes 14 and the second wirings 15 are exposed to the outside. This enables the through-electrodes 14 and the second wirings 15 to be electrically connected to, for example, another semiconductor package or a wiring substrate. The support carrier 50 has a size that covers the whole of a combination of the interposer 20 and the redistribution layer chip 30. An example of the shape of the support carrier 50 may be a rectangular shape. In an illustrated example, the support carrier 50 supports the single combination of the interposer 20 and the redistribution layer chip 30 but may support multiple combinations of the interposers 20 and the redistribution layer chips 30.

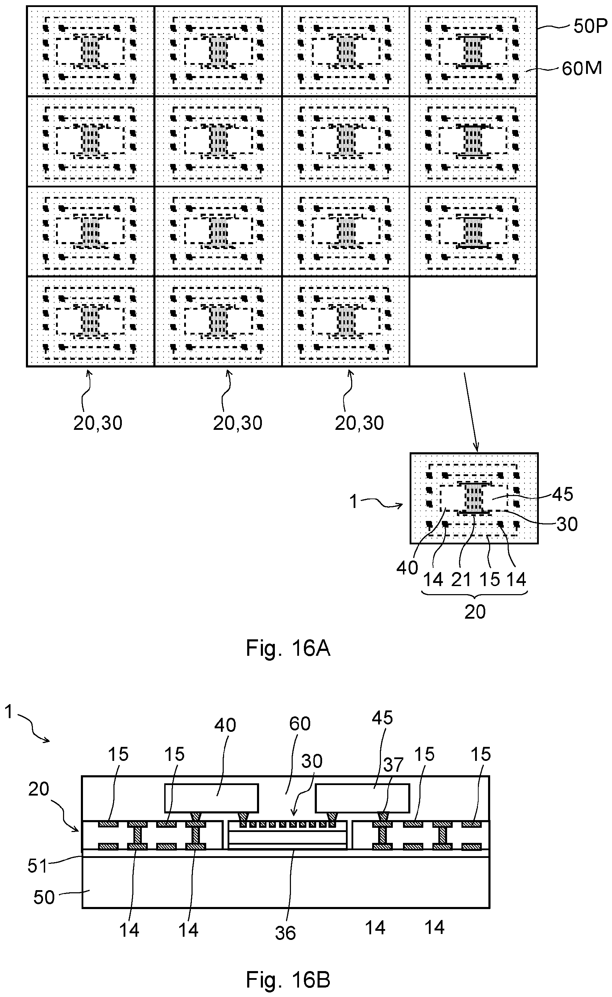

The semiconductor package 1 according to the present embodiment is formed by being cut out of a support carrier substrate 50P (see Fig. 16A) that supports the multiple combinations of the interposers 20 and the redistribution layer chips 30 described later. The support carrier 50 is a portion of the support carrier substrate 50P and is cut out of the support carrier substrate 50P. On the support carrier 50 cut, the interposer 20, the redistribution layer chip 30, the semiconductor elements 40 and 45, and the second mold resin layer 60 corresponding thereto are mounted.

For example, the support carrier 50 may include a glass substrate, a quartz substrate, a sapphire substrate, a resin substrate, a silicon substrate, a silicon carbide substrate, an alumina (Al2O3) substrate, an aluminum nitride (AIN) substrate, a zirconium oxide (ZrO2) substrate, a lithium niobate substrate, or a tantalum niobate substrate. The resin substrate may contain an organic material. For example, the resin substrate may contain epoxy resin, polyethylene, or polypropylene. For example, the thickness of the support carrier 50 is 100 µm or more, may be 200 µm or more, or may be 500 µm or more. For example, the thickness of the support carrier 50 is 2 mm or less, may be 1.5 mm or less, or may be 1 mm or less.

The release layer 51 is joined to the second surface 20B of the interposer 20 and the second surface 30B of the redistribution layer chip 30 and is joined to the support carrier 50. The release layer 51 can be separated from the second surface 20B of the interposer 20 and the second surface 30B of the redistribution layer chip 30 and may be separated, for example, by being heated. In this case, the release layer 51 may contain thermoplastic resin. For example, the thickness of the release layer 51 is 0.3 µm or more or may be 1 µm or more. For example, the thickness of the release layer 51 is 30 µm or less or may be 50 µm or less.

The second mold resin layer 60 contains resin, and examples of the resin that is contained in the second mold resin layer 60 may include polyimide, epoxy resin, acryl, bismaleimide, polybenzoxazole, benzocyclobutene, or a combination of two or more of these. The second mold resin layer 60 may contain thermosetting resin. The resin that is contained in the second mold resin layer 60 may be thermosetting epoxy resin. The second mold resin layer 60 covers the interposer 20, the redistribution layer chip 30, the first semiconductor element 40, and the second semiconductor element 45. The second mold resin layer 60 is joined to the interposer 20, the redistribution layer chip 30, the first semiconductor element 40, and the second semiconductor element 45. Consequently, the second mold resin layer 60 is mounted to the interposer 20 and the redistribution layer chip 30 and holds the first semiconductor element 40 and the second semiconductor element 45 in this state.

As illustrated in Fig. 2, the second mold resin layer 60 may cover the whole of the first semiconductor element 40 and the second semiconductor element 45. The second mold resin layer 60 may cover the first semiconductor element 40 and the second semiconductor element 45 with portions thereof exposed. The second mold resin layer 60 may fill a gap between the through-portion 21 in the interposer 20 and the redistribution layer chip 30. The second mold resin layer 60 may be joined to side surfaces of the redistribution layer chip 30 and the through-portion 21. For example, the thickness of the second mold resin layer 60 is 30 µm or more or may be 100 µm or more. For example, the thickness of the second mold resin layer 60 is 300 µm or less or may be 600 µm or less. The thickness of the second mold resin layer 60 is equal to a distance from the surface in contact with the interposer 20 to the opposite surface.

A method of manufacturing the semiconductor package 1 according to the present embodiment will now be described. As for the manufacturing method described later, a procedure for manufacturing the redistribution layer chip intermediate 300 that is used as the base material of the redistribution layer chip 30 will be first described. A procedure for manufacturing the redistribution layer chip 30 that is manufactured from the redistribution layer chip intermediate 300 will be next described. A procedure for manufacturing the semiconductor package 1 that is manufactured by using the redistribution layer chip 30 will be then described.

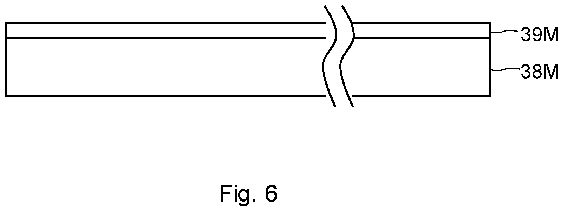

When the redistribution layer chip intermediate 300 is manufactured, as illustrated in Fig. 6, a chip carrier substrate 38M is prepared. A release layer 39M is formed on the chip carrier substrate 38M. The redistribution layer chip 30 is one of multiple chips that are cut out of the redistribution layer chip intermediate 300. The release layer 39M corresponds to a portion that includes the release layer 39 before the release layer 39 is cut as a component of the redistribution layer chip 30.

For example, the chip carrier substrate 38M may be a glass substrate or a silicon substrate (a wafer). The shape of the chip carrier substrate 38M may be a circular shape such as a wafer. For example, the diameter of the chip carrier substrate 38M is 100 mm or more, may be 150 mm or more, or may be 200 mm or more. For example, the diameter of the chip carrier substrate 38M is 400 mm or less, may be 350 mm or less, or may be 300 mm or less. In this case, when forming the first redistribution layer 34, a fine wiring can be formed on the chip carrier substrate 38M by using a small exposure device compared with a case where the first redistribution layer 34 is formed on the support carrier substrate 50P described later larger than the chip carrier substrate 38M. For example, the release layer 39M may contain thermoplastic resin. For example, the release layer 39M may be formed in a manner in which a thermoplastic resin film is joined to the chip carrier substrate 38M.

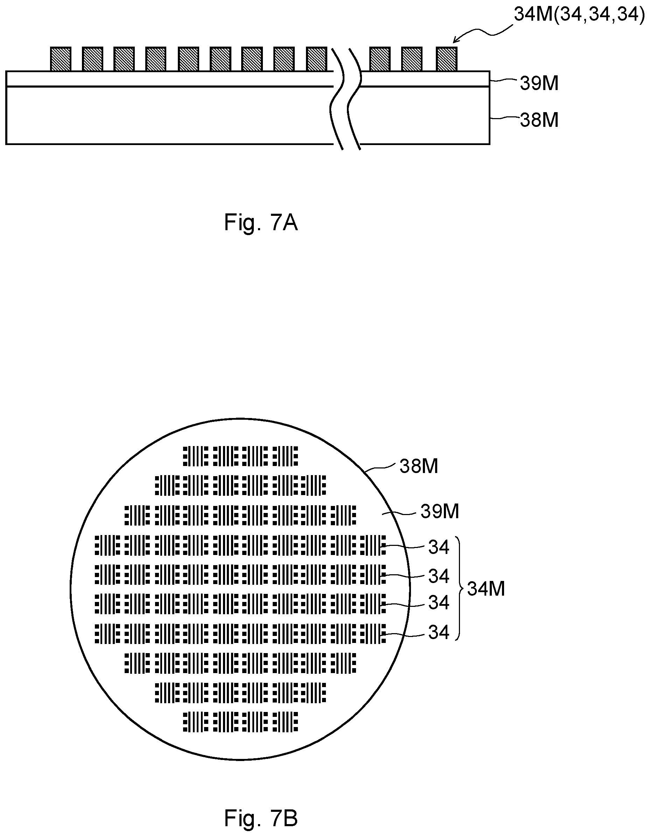

Subsequently, as illustrated in Fig. 7A, multiple first redistribution layers 34 are formed on the release layer 39M. In this example, as illustrated in Fig. 7B, the first redistribution layers 34 are formed along the chip carrier substrate 38M that has a circular shape. The multiple first redistribution layers 34 illustrated in Fig. 7A and Fig. 7B include wirings that form the multiple redistribution layer chips 30. The multiple first redistribution layers 34 are also referred to as a redistribution layer group 34M. The redistribution layer group 34M may be formed by using photolithography. In this case, for example, a conductive layer composed of, for example, copper is provided on the chip carrier substrate 38M. Subsequently, a photosensitive resist film is provided on the conductive layer. Subsequently, the resist film is exposed to light in a desired pattern that corresponds to the first redistribution layers 34 by using an exposure device. Subsequently, the resist film is removed. Subsequently, the conductive layer is etched, and consequently, the redistribution layer group 34M is formed.

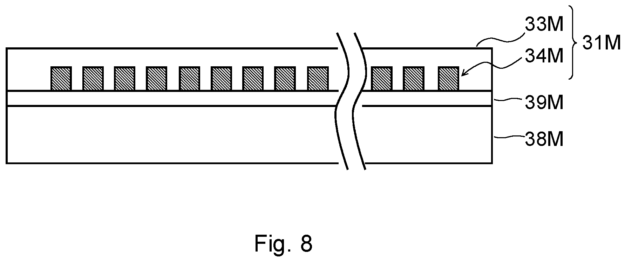

Subsequently, as illustrated in Fig. 8, the redistribution layer group 34M is covered by an insulating layer 33M. The insulating layer 33M corresponds to a portion that includes the insulating layer 33 before the insulating layer 33 is cut as a component of the redistribution layer chip 30. For example, the insulating layer 33M may be formed in a manner in which a material composed of polyimide, epoxy resin, acryl resin, or a combination of two or more of these is hardened. The insulating layer 33M covers surfaces of the redistribution layer group 34M other than the surface in contact with the release layer 39M such that the redistribution layer group 34M is not exposed. The redistribution layer group 34M and the insulating layer 33M form a redistribution element portion 31M. The redistribution element portion 31M corresponds to a portion that includes the redistribution element 31 before the redistribution element 31 is cut as a component of the redistribution layer chip 30.

Subsequently, as illustrated in Fig. 9A, the insulating layer 33M is covered by a first mold resin layer portion 32M. The first mold resin layer portion 32M corresponds to a portion that includes the first mold resin layers 32 before each first mold resin layer 32 is cut as a component of the redistribution layer chip 30. For example, the first mold resin layer portion 32M may be formed in a manner in which a material composed of polyimide, epoxy resin, acryl, bismaleimide, polybenzoxazole, benzocyclobutene, or a combination of two or more of these is hardened. Subsequently, as illustrated in Fig. 9A and Fig. 9B, the first mold resin layer portion 32M is covered by an adhesive layer 36M. The adhesive layer 36M corresponds to a portion that includes the adhesive layers 36 before each adhesive layer 36 is cut as a component of the redistribution layer chip 30. The adhesive layer 36M may be composed of thermoplastic polyimide that has the heat-sensitive adhesiveness.

The redistribution layer chip intermediate 300 is manufactured through the procedures described above. The redistribution layer chip intermediate 300 includes the redistribution element portion 31M, the first mold resin layer portion 32M that contains resin, and the chip carrier substrate 38M. The redistribution element portion 31M includes the insulating layer 33M that has the insulation properties and the multiple first redistribution layers 34 that are embedded in, in other words, covered by the insulating layer 33M and has a first surface (a lower surface in Fig. 9A) and a second surface (an upper surface in Fig. 9A) opposite the first surface. The first redistribution layers 34 include first conductive portions 30E that include the first wirings 35 that are at least partly located at the first surface. The first mold resin layer portion 32M is mounted to the second surface of the redistribution element portion 31M. The chip carrier substrate 38M is connected to the first surface of the redistribution element portion 31M with the release layer 39M interposed therebetween and supports the redistribution element portion 31M and the first mold resin layer portion 32M. The redistribution layer chip intermediate 300 further includes the adhesive layer 36M that is mounted to the first mold resin layer portion 32M and the release layer 39M that is provided between the redistribution element portion 31M and the chip carrier substrate 38M.

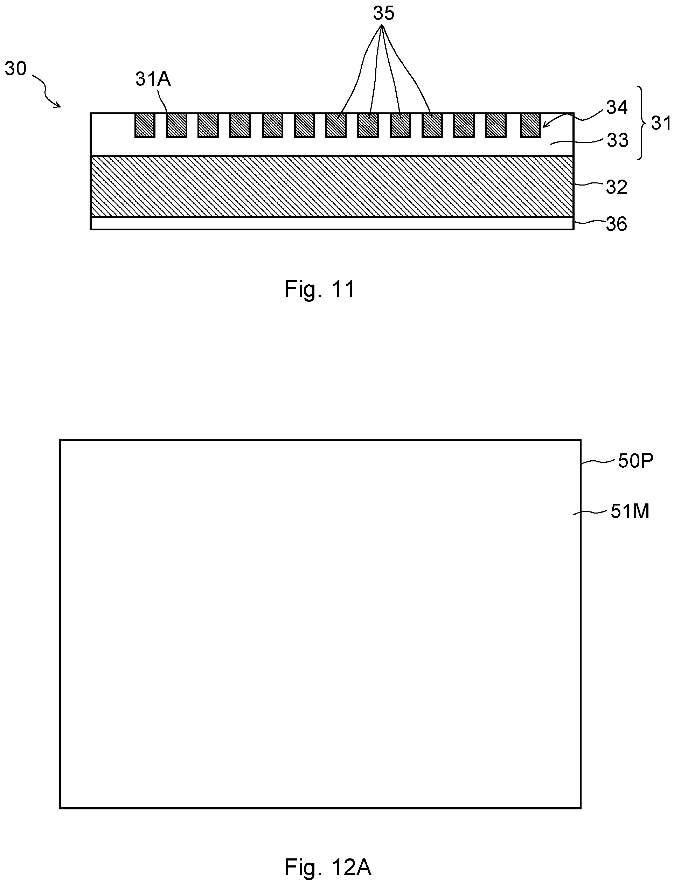

Subsequently, as illustrated in Fig. 10A and Fig. 10B, the redistribution layer chip intermediate 300 is cut into multiple pieces. Consequently, the multiple redistribution layer chips 30 are cut out of the redistribution layer chip intermediate 300. Consequently, the redistribution layer chip 30 is manufactured. In a precise sense, the pre-incorporation redistribution layer chip 30' is illustrated in Fig. 10A and Fig. 10B. In Fig. 11, the redistribution layer chip 30 from which the chip carrier 38 and the release layer 39 are removed is illustrated. The redistribution layer chip 30 is incorporated as a portion of the semiconductor package 1 after the chip carrier 38 and the release layer 39 are removed. A multilayer body that includes the redistribution element portion 31M and the first mold resin layer portion 32M may be cut into multiple pieces after the chip carrier substrate 38M and the release layer 39M are separated from the redistribution element portion 31M although this is not illustrated.

Procedures for manufacturing the semiconductor package 1 will now be described. As illustrated in Fig. 12A, the support carrier substrate 50P is prepared. For example, the area of the support carrier substrate 50P is 0.5 m² or more, may be 1.0 m² or more, may be 2.0 m² or more, or may be 3.0 m² or more. A release layer 51M is formed on the support carrier substrate 50P. The release layer 51M corresponds to a portion that includes the release layer 51 before the release layer 51 is cut as a component of the semiconductor package 1.

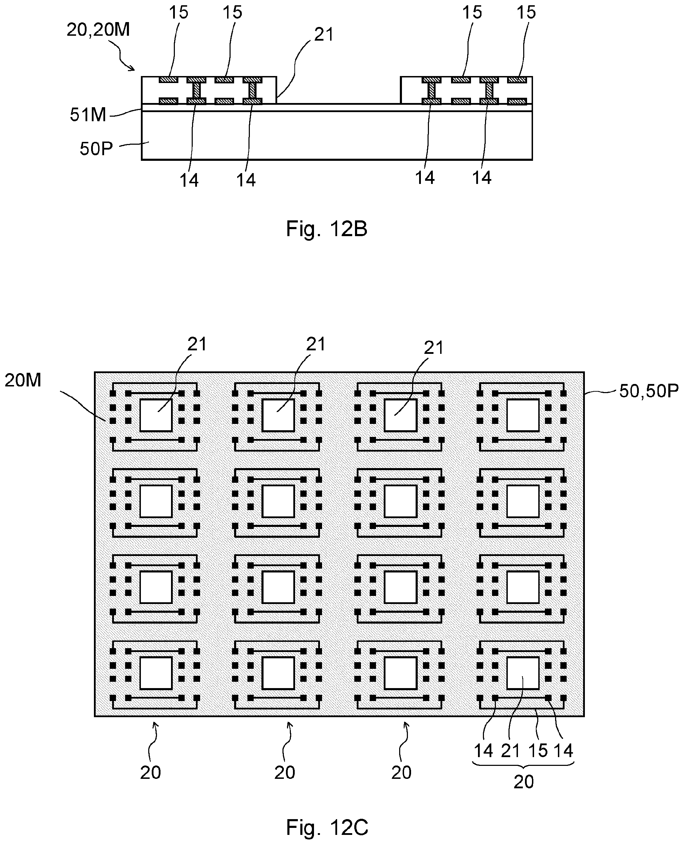

Subsequently, as illustrated in Fig. 12B and Fig. 12C, an interposer layer 20M is formed above the support carrier substrate 50P. The interposer layer 20M corresponds to a portion that includes multiple interposers 20 before each interposer 20 is cut as a component of the semiconductor package 1. The interposer layer 20M includes multiple through-portions 21. The multiple redistribution layer chips 30 are prepared.

The redistribution layer chips 30 are placed at the multiple through-portions 21. Specifically, as illustrated in Fig. 13A and Fig. 13B, the redistribution layer chips 30 are placed so as to be adjacent to the respective interposers 20 of the multiple interposers 20 that are included in the interposer layer 20M, and the redistribution layer chips 30 are mounted to the support carrier substrate 50P. The redistribution layer chips 30 are joined to the release layer 51M with the adhesive layers 36 interposed therebetween and are consequently mounted to the support carrier substrate 50P. For example, in the case where the adhesive layers 36 have the heat-sensitive adhesiveness, the redistribution layer chips 30 are placed with the adhesive layers 36 being in contact with the release layer 51M. For example, the adhesive layers 36 may be heated, and consequently, the adhesive layers 36 and the release layer 51M may be joined.

The redistribution layer chips 30 are mounted to the support carrier substrate 50P as described above, and consequently, a semiconductor package intermediate 1M illustrated in Fig. 13A and Fig. 13B is manufactured. The semiconductor package intermediate 1M includes the interposers 20, the redistribution layer chips 30 adjacent to the interposers 20, and the support carrier substrate 50P that supports the interposers 20 and the redistribution layer chips 30. More specifically, the semiconductor package intermediate 1M includes the interposer layer 20M that includes the multiple interposers 20, the multiple redistribution layer chips 30 adjacent to the multiple interposers 20, and the support carrier substrate 50P that supports the multiple interposers 20 and the redistribution layer chips 30.

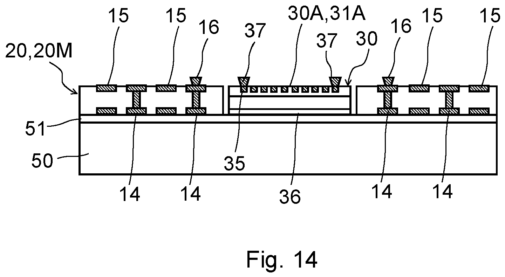

Subsequently, as illustrated in Fig. 14, the pads 16 are provided at the first surfaces 20A of the interposers 20. The pads 16 are electrically connected to the through-electrodes 14. The pads 37 are formed at the first surfaces 31A that are formed by portions of the first wirings 35 of the redistribution layer chips 30. The pads 37 are electrically connected to the first wirings 35.

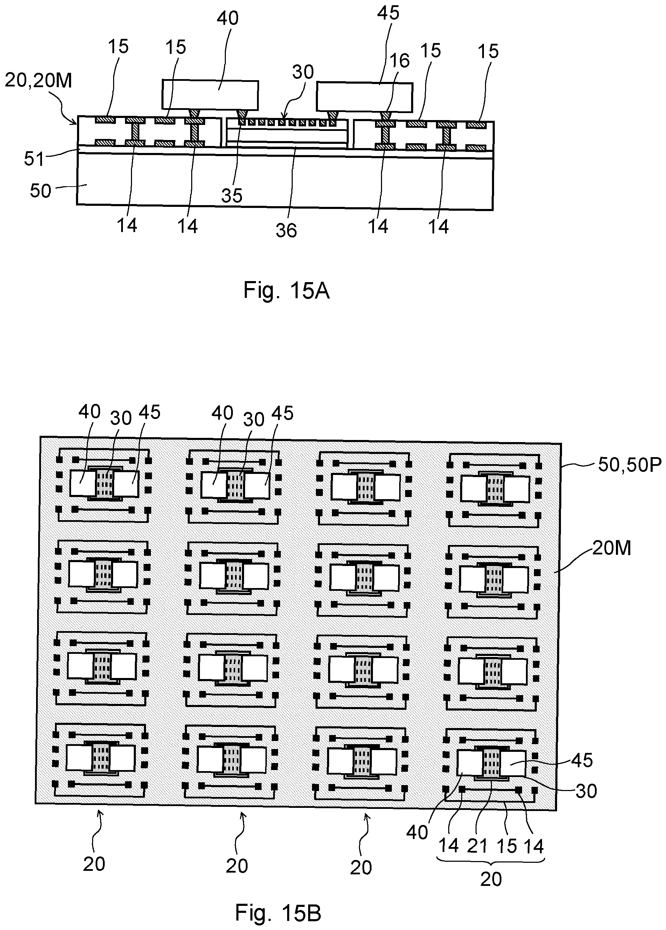

Subsequently, as illustrated in Fig. 15A and Fig. 15B, the first semiconductor elements 40 and the second semiconductor elements 45 are mounted so as to overlap the interposers 20 and the redistribution layer chips 30. Here, multiple combinations of the first semiconductor elements 40 and the second semiconductor elements 45 overlap the respective interposers 20 and the respective redistribution layer chips 30. The first semiconductor elements 40 are electrically connected to the through-electrodes 14 of the interposers 20 with the pads 16 interposed therebetween. The first semiconductor elements 40 are electrically connected to the first wirings 35 of the redistribution layer chips 30 with the pads 37 interposed therebetween. The second semiconductor elements 45 are electrically connected to the through-electrodes 14 of the interposers 20 with the pads 16 interposed therebetween. The second semiconductor elements 45 are electrically connected to the first wirings 35 of the redistribution layer chips 30 with the pads 37 interposed therebetween.

Subsequently, as illustrated in Fig. 16A, a second mold resin layer portion 60M is provided. The second mold resin layer portion 60M corresponds to a portion that includes the second mold resin layer 60 before the second mold resin layer 60 is cut as a component of each redistribution layer chip 30. Consequently, a semiconductor package block that includes the multiple semiconductor packages 1 is formed. Subsequently, as illustrated in Fig. 16A and Fig. 16B, the semiconductor packages 1 are cut out of the block described above. The second mold resin layer portion 60M is joined to the first surfaces 20A of the multiple interposers 20 and the first surfaces 30A of the redistribution layer chips 30. The second mold resin layer portion 60M is joined to the multiple first semiconductor elements 40 and the second semiconductor elements 45 and holds the multiple first semiconductor elements 40 and the second semiconductor elements 45. Consequently, even in the case where the support carrier 50 is separated from the interposers 20 and the redistribution layer chips 30 after the semiconductor packages 1 are cut out of the block, the second mold resin layer 60 maintains the interposers 20, the redistribution layer chips 30, the first semiconductor elements 40, and the second semiconductor elements 45 that are connected as respective bodies. The second mold resin layer portion 60M may be formed in a manner in which a softened material is hardened. The second mold resin layer portion 60M may be formed in a manner in which a liquid material is solidified.

Each semiconductor package 1 described above includes the interposer 20, the redistribution layer chip 30 adjacent to the interposer 20, and the semiconductor elements 40 and 45 that overlap the interposer 20 and the redistribution layer chip 30. The redistribution layer chip 30 includes the redistribution element 31 that has the first surface 31A overlapping the semiconductor elements 40 and 45, and the first mold resin layer 32 that is mounted to the second surface 31B of the redistribution element 31 opposite the surface overlapping the semiconductor elements 40 and 45 and that contains resin. The redistribution element 31 includes the insulating layer 33 that has the insulation properties and the first redistribution layer 34 that is covered by the insulating layer 33. The first redistribution layer 34 includes the first conductive portion 30E that includes the first wirings 35 that are at least partly located at the first surface 31A of the redistribution element 31 overlapping the semiconductor elements 40 and 45. The interposer 20 includes the second conductive portion 20E that includes the through-electrodes 14 that are located at the surface of the interposer 20 overlapping the semiconductor elements 40 and 45. The semiconductor elements 40 and 45 are electrically connected to the first conductive portion 30E and the second conductive portion 20E.

As for the semiconductor package 1, the interposer 20 and the redistribution layer chip 30 are separately manufactured. The interposer 20 and the redistribution layer chip 30 are connected as a single body, and consequently, the semiconductor package 1 is manufactured. This enables the semiconductor package 1 that is large to be provided at low costs. That is, in the case where the interposer 20 and the portion that corresponds to the redistribution layer chip 30 are simultaneously formed above the support carrier substrate 50P or the support carrier 50, it can be necessary to increase the size of a device such as the exposure device for forming a fine wiring pattern such as the pattern that the redistribution layer chip 30 has because the entire size is large. In this case, equipment costs can increase. In the case where the redistribution layer chip 30 is manufactured at a location different from that for the support carrier substrate 50P or the support carrier 50, the redistribution layer chip 30 can be manufactured by, for example, an existing small device. For this reason, the semiconductor package 1 that is large can be efficiently provided at low costs.

In the case where the interposer 20 and the redistribution layer chip 30 are separately manufactured, the interposer 20 and the redistribution layer chip 30 are connected as a single body, and consequently, the semiconductor package 1 is manufactured. At this time, the redistribution layer chip 30 includes the redistribution element 31 and the first mold resin layer 32. The first mold resin layer 32 has a function of inhibiting the redistribution element 31 from deforming. Specifically, as for the redistribution layer chip 30, the insulating layer 33 and the first redistribution layer 34 have the different thermal expansion coefficients, and accordingly, the redistribution element 31 is likely to warp. At this time, the first mold resin layer 32 reinforces the insulating layer 33 and inhibits the redistribution element 31 from warping. Accordingly, as for the semiconductor package 1, the redistribution layer chip 30 is inhibited from partly deforming such as warping or distorting. As a result, a portion at which the interposer 20 and the redistribution layer chip are continuous can be flattened, and consequently, the semiconductor package 1 can be entirely flattened. This enables the semiconductor package 1 that is large to be formed in a plane direction.

According to the present embodiment, the semiconductor package 1 that is large can be provided at low costs. In addition, the semiconductor package 1 can be inhibited from deforming.

An embodiment described above can be modified in various ways. Modifications will now be described with reference to the drawings as needed. In the description below and the drawings that are used in the description below, as for a portion that can be the same as in an embodiment described above, the same reference sign as the reference sign that is used for a corresponding portion according to an embodiment described above is used. A duplicated description is omitted. In the case where the action and effect according to an embodiment described above are clearly achieved also according to another embodiment, the description thereof is omitted in some cases.

### (Modification)

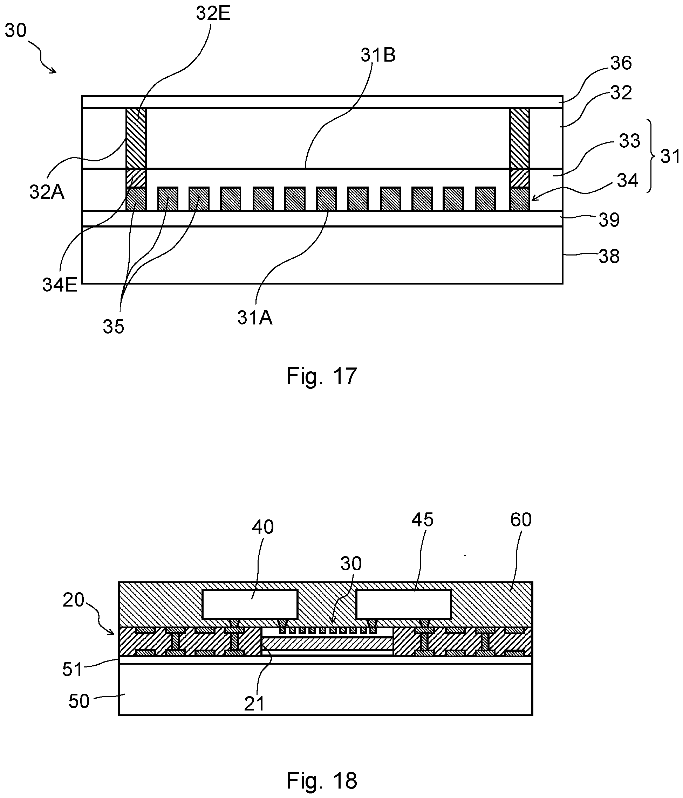

Fig. 17 illustrates a modification to the redistribution layer chip 30. The redistribution layer chip 30 according to the modification illustrated in Fig. 17 further includes through-electrodes 32E that are located in through-holes 32A that are formed in the first mold resin layer 32. The through-electrodes 32E are electrically connected to the first redistribution layer 34.

In Fig. 17, portions of the first redistribution layer 34 in the redistribution element 31 are located at the first surface 31A and the second surface 31B of the redistribution element 31. Specifically, portions of the first wirings 35 that are located at the first surface 31A and portions that include conductive portions 34E that extend from the portions of the first wirings 35 to the second surface 31B through the insulating layer 33 are located at the first surface 31A and the second surface 31B of the redistribution element 31. The through-electrodes 32E are connected to the conductive portions 34E. In the case where the conductive portions 34E are formed, for example, the first wirings 35 are covered by the insulating layer 33 after the first wirings 35 are formed on the release layer 39 (39M). Subsequently, holes for exposing the portions of the first wirings 35 from the second surface 31B are formed in the insulating layer 33, and the conductive portions 34E are provided in the holes. The conductive portions 34E may be formed by using the electroplating method.

Fig. 18 illustrates a modification to the semiconductor package 1 in Fig. 1. As for the semiconductor package 1 according to the modification illustrated in Fig. 18, there is no gap between the redistribution layer chip 30 that is placed at the through-portion 21 of the interposer 20 and the interposer 20. The same material as the forming material of the insulating layer 33 or the second mold resin layer 60 may fill the gap between the redistribution layer chip 30 and the interposer 20.

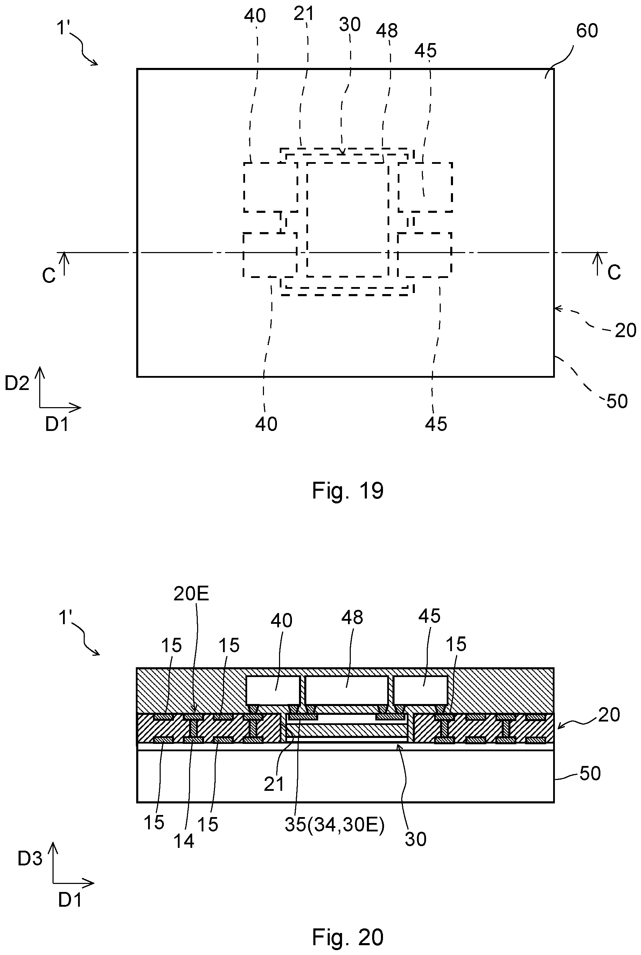

Fig. 19 illustrates a semiconductor package 1' according to a modification. Fig. 20 is a sectional view of the semiconductor package 1' in Fig. 19 taken along line C-C. The semiconductor package 1' includes the interposer 20, the redistribution layer chip 30, two first semiconductor elements 40, two second semiconductor elements 45, a third semiconductor element 48, the support carrier 50, and the second mold resin layer 60. The interposer 20 includes the through-portion 21 that has a hole extending in the thickness direction. The redistribution layer chip 30 is placed at the through-portion 21.

One of the two first semiconductor elements 40 overlaps the interposer 20 and the redistribution layer chip 30 in plan view, in other words, when viewed in the third direction D3. The other of the two first semiconductor elements 40 overlaps the interposer 20 and the redistribution layer chip 30 at a position different from the position of the one described above in plan view, in other words, when viewed in the third direction D3. The first semiconductor elements 40 are electrically connected to both of the interposer 20 and the redistribution layer chip 30. Specifically, one of the multiple through-electrodes 14 or the multiple through-electrodes 14 in the interposer 20 are electrically connected to the two first semiconductor elements 40. The redistribution layer chip 30 includes the first conductive portion 30E that includes the first wirings 35 that are electrically connected to the first semiconductor elements 40.

One of the two second semiconductor elements 45 overlaps the interposer 20 and the redistribution layer chip 30 in plan view, in other words, when viewed in the third direction D3. The other of the two second semiconductor elements 45 overlaps the interposer 20 and the redistribution layer chip 30 at a position different from the position of the one described above in plan view, in other words, when viewed in the third direction D3. The second semiconductor elements 45 are electrically connected to both of the interposer 20 and the redistribution layer chip 30. Specifically, one of the multiple through-electrodes 14 or the multiple through-electrodes 14 in the second conductive portion 20E of the interposer 20 are electrically connected to the two second semiconductor elements 45. The redistribution layer chip 30 includes the first wirings 35 that are electrically connected to the second semiconductor elements 45.

The third semiconductor element 48 overlaps the redistribution layer chip 30 in plan view, in other words, when viewed in the third direction D3. The third semiconductor element 48 is electrically connected to the first wirings 35 of the redistribution layer chip 30. Specifically, the third semiconductor element 48 is electrically connected to the first wirings 35 that are electrically connected to the first semiconductor elements 40. The third semiconductor element 48 is electrically connected to the first wirings 35 that are electrically connected to the second semiconductor elements 45. Consequently, the first semiconductor elements 40, the third semiconductor element 48, and the second semiconductor elements 45 are electrically connected to each other.

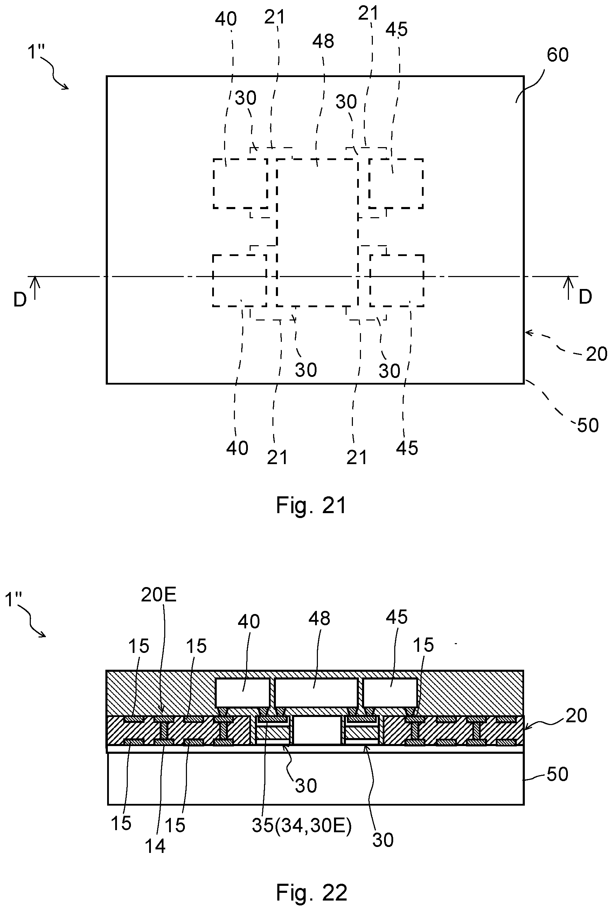

Fig. 21 illustrates a semiconductor package 1" according to a modification. Fig. 22 is a sectional view of the semiconductor package 1" in Fig. 21 taken along line D-D. The semiconductor package 1" includes the interposer 20, four redistribution layer chips 30, two first semiconductor elements 40, two second semiconductor elements 45, the third semiconductor element 48, the support carrier 50, and the second mold resin layer 60. The interposer 20 includes four through-portions 21 that have holes extending in the thickness direction. The four redistribution layer chips 30 are placed at the respective through-portions 21.

The multiple redistribution layer chips 30 may be incorporated into the single interposer 20 as in the modification illustrated in Fig. 21 and Fig. 22.

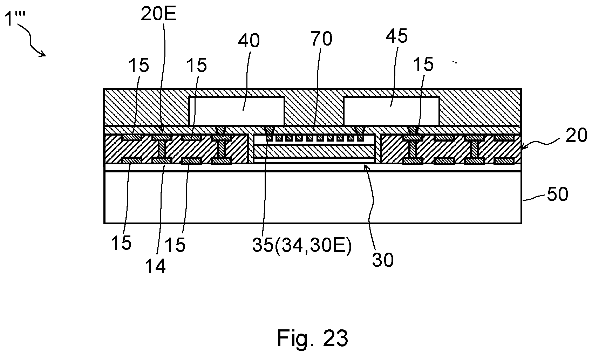

Fig. 23 illustrates a semiconductor package 1‴ according to a modification. The semiconductor package 1‴ differs from the semiconductor package 1 illustrated in Fig. 2 in that a second insulating layer 70 is provided between the interposer 20 and the second mold resin layer 60 and between the redistribution layer chip 30 and the second mold resin layer 60. Examples of the second insulating layer 70 may include polyimide, epoxy resin, acryl resin, or a combination of two or more of these. In an illustrated example, the pads 16 and 37 are embedded in the second insulating layer 70.

Fig. 24 illustrates a semiconductor package intermediate 1M' according to a modification. The semiconductor package intermediate 1M' includes the interposers 20, the redistribution layer chips 30 adjacent to the interposers 20, and the support carrier substrate 50P that supports the interposers 20 and the redistribution layer chips 30. Fig. 24 illustrates only a portion of the semiconductor package intermediate 1M'. In practice, the semiconductor package intermediate 1M' includes the interposer layer 20M that includes the multiple interposers 20, the multiple redistribution layer chips 30 adjacent to the multiple interposers 20, and the support carrier substrate 50P that supports the multiple interposers 20 and the redistribution layer chips 30.

As for the semiconductor package intermediate 1M' in Fig. 24, the first surfaces 20A of the interposers 20 are covered by a third insulating layer 80. The pads 16 are provided on the third insulating layer 80. The pads 16 project from the first surfaces 20A. The pads 16 are electrically connected to the through-electrodes 14 that are exposed from the first surfaces 20A in the interposers 20 with connection conductive portions 16a that extend through the third insulating layer 80 interposed therebetween. The first wirings 35 are embedded in the insulating layers 33 in the redistribution elements 31 of the redistribution layer chips 30, and connection conductive portions 37a that are electrically connected to portions of the first wirings 35 are provided on the insulating layers 33. The pads 37 are provided on the redistribution layer chips 30. The pads 37 project from the first surfaces 30A of the redistribution layer chips 30. The pads 37 are electrically connected to the first wirings 35 with the connection conductive portions 37a interposed therebetween.

That is, the semiconductor package intermediate 1M' integrally includes the pads 16 and 37, the pads 16 are held by the third insulating layer 80, and the pads 37 are held by the insulating layers 33. When the first semiconductor elements 40 and the second semiconductor elements 45 are mounted to the semiconductor package intermediate 1M', the first semiconductor elements 40 and the second semiconductor elements 45 overlap the third insulating layer 80 and the insulating layers 33 and overlap the interposers 20 and the redistribution layer chips 30. Examples of the third insulating layer 80 may include polyimide, epoxy resin, acryl resin, or a combination of two or more of these. As for the semiconductor package intermediate 1M', a bump may be formed instead of the pads 16 and 37.

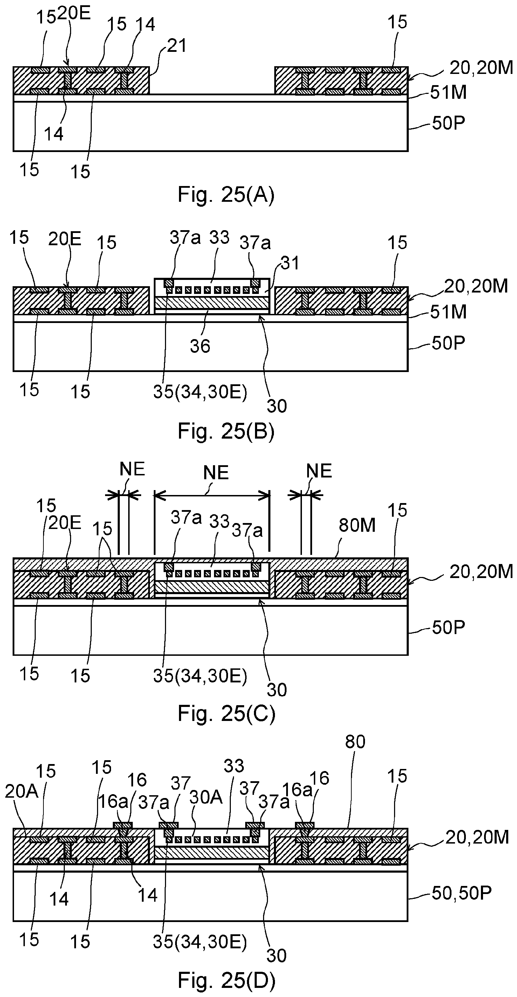

Fig. 25 illustrates an example of a method of manufacturing the semiconductor package intermediate 1M'. As illustrated in Fig. 25(A), the support carrier substrate 50P along which the interposer layer 20M is formed is prepared. The interposer layer 20M corresponds to a portion that includes the multiple interposers 20 before each interposer 20 is cut as a component of the semiconductor package 1. The interposer layer 20M includes the multiple through-portions 21.

Subsequently, the multiple redistribution layer chips 30 are prepared. As for the redistribution layer chips 30 according to the modification, the connection conductive portions 37a are exposed from the insulating layers 33 and are integrated to each of the redistribution elements 31. As illustrated in Fig. 25(B), the redistribution layer chips 30 are placed at the multiple through-portions 21, and the redistribution layer chips 30 are mounted to the support carrier substrate 50P. The redistribution layer chips 30 are joined to the release layer 51M with the adhesive layers 36 interposed therebetween and is consequently mounted to the support carrier substrate 50P.

Subsequently, as illustrated in Fig. 25(C), a forming material 80M that forms the third insulating layer 80 is provided on the interposers 20 and the redistribution layer chips 30. The forming material 80M covers the first surfaces 20A of the interposers 20 and covers the redistribution layer chips 30. An example of the forming material 80M is a film and may be provided by vacuum lamination so as to adhere to the interposers 20 and the redistribution layer chips 30. In an illustrated example, a portion of the forming material 80M fills a gap between the interposers 20 and the redistribution layer chips 30.

The forming material 80M is a photosensitive material, and portions other than non-exposure portions NE illustrated in Fig. 25(C) are exposed to light. The portions of the forming material 80M that are exposed to light are hardened, and the non-exposure portions NE are not hardened. Subsequently, the non-exposure portions NE are removed, and the third insulating layer 80 that has through-holes is formed. The redistribution layer chips 30 are exposed to the outside. Plating is growth in the through-holes in the third insulating layer 80 by, for example, the electroplating method.

The plating is sufFiciently grown in the through-holes in the third insulating layer 80, and consequently, the connection conductive portions 16a are formed as illustrated in Fig. 25(D). Subsequently, plating is grown from the connection conductive portions 16a and 37a, and consequently, the pads 16 and 37 are formed. Consequently, the semiconductor package intermediate 1M' is obtained. In the case where a bump is formed instead of the pads 16 and 37, the bump may be formed by using a plating method or a printing method.

Fig. 26A and Fig. 26B are diagrams for describing a method of manufacturing the redistribution layer chips 30 that are included in a semiconductor package intermediate 1M'.

In this example, as illustrated in Fig. 26A(A), a pre-processed chip carrier substrate 38M' is prepared. A pre-processed release layer 39M' is formed on the pre-processed chip carrier substrate 38M'. Subsequently, as illustrated in Fig. 26A(B), the multiple first redistribution layers 34 are formed on the pre-processed release layer 39M'. In Fig. 26A(B), only one of the first redistribution layers 34 is illustrated, but the multiple first redistribution layers 34 are formed in practice. The multiple first redistribution layers 34 include the wirings that form the multiple redistribution layer chips 30.

Subsequently, as illustrated in Fig. 26A(C), the multiple first redistribution layers 34 are covered by a pre-processed insulating layer 33M1. The pre-processed insulating layer 33M1 is a photosensitive material. For example, the pre-processed insulating layer 33M1 may be formed in a manner in which a material composed of polyimide, epoxy resin, acryl resin, or a combination of two or more of these is hardened.

Subsequently, regions of the pre-processed insulating layer 33M1 other than the non-exposure portions NE illustrated in Fig. 26A(C) are exposed to light. The non-exposure portions NE are removed, and portions of the pre-processed insulating layer 33M1 that are not removed are hardened. Consequently, holes for exposing some wirings in the first redistribution layers 34 are formed. Plating is grown by, for example, the electroplating method in the holes that are formed in the pre-processed insulating layer 33M1, and consequently, the connection conductive portions 37a are formed as illustrated in Fig. 26A(D).

As illustrated in Fig. 26A(E), the pre-processed chip carrier substrate 38M' and the pre-processed release layer 39M' are separated from the pre-processed insulating layer 33M1 in which the first redistribution layers 34 and the connection conductive portions 37a are formed.

Subsequently, as illustrated in Fig. 26B(F), the chip carrier substrate 38M is prepared, and the release layer 39M is formed on the chip carrier substrate 38M. The release layer 39M and the pre-processed insulating layer 33M1 are bonded to each other such that the connection conductive portions 37a are in contact with the release layer 39M. Subsequently, as illustrated in Fig. 26B(G), a post-processed insulating layer 33M2 is provided on the pre-processed insulating layer 33M1. The post-processed insulating layer 33M2 covers the first redistribution layers 34. The pre-processed insulating layer 33M1 and the post-processed insulating layer 33M2 form the insulating layer 33M. Subsequently, as illustrated in Fig. 26B(H), the insulating layer 33M is covered by the first mold resin layer portion 32M and the adhesive layer 36M. Consequently, the redistribution layer chip intermediate is formed. The multiple redistribution layer chips 30 are cut out of the redistribution layer chip intermediate.

Fig. 26C and Fig. 26D are diagrams for describing another method of manufacturing the redistribution layer chips 30. In this example, the connection conductive portions 37a and the pads 37 are integrated to the redistribution layer chips 30 before the redistribution layer chips 30 are incorporated into the interposers 20.

In this example, as illustrated in Fig. 26C(A), the pre-processed chip carrier substrate 38M' is prepared. The pre-processed release layer 39M' is formed on the pre-processed chip carrier substrate 38M'. Subsequently, as illustrated in Fig. 26C(B), the multiple first redistribution layers 34 are formed on the pre-processed release layer 39M'. The multiple first redistribution layers 34 include the wirings that form the multiple redistribution layer chips 30. Subsequently, as illustrated in Fig. 26C(C), the multiple first redistribution layers 34 are covered by the pre-processed insulating layer 33M1.

Subsequently, the pre-processed chip carrier substrate 38M' and the pre-processed release layer 39M' are separated from the first redistribution layers 34 and the pre-processed insulating layer 33M1. As illustrated in Fig. 26C(D), a halfway-processed chip carrier substrate 38M" and a halfway-processed release layer 39M" are provided on surfaces opposite surfaces of the first redistribution layers 34 and the pre-processed insulating layer 33M1 on which the pre-processed chip carrier substrate 38M' and the pre-processed release layer 39M' were provided.

Subsequently, as illustrated in Fig. 26C(E), the post-processed insulating layer 33M2 is formed on the surface from which the first redistribution layers 34 are exposed. The post-processed insulating layer 33M2 covers the first redistribution layers 34. Subsequently, the regions of the post-processed insulating layer 33M2 other than the non-exposure portions NE illustrated in Fig. 26C(E) are exposed to light. The non-exposure portions NE are removed, and portions of the post-processed insulating layer 33M2 that are not removed are hardened. Consequently, the holes for exposing some wirings in the first redistribution layers 34 are formed. Plating is grown by, for example, the electroplating method in the holes that are formed in the post-processed insulating layer 33M2, and consequently, the connection conductive portions 37a are formed as illustrated in Fig. 26C(F). The pre-processed insulating layer 33M1 and the post-processed insulating layer 33M2 form the insulating layer 33M.

Subsequently, as illustrated in Fig. 26D(G), plating is grown from the connection conductive portions 37a, and consequently, the pads 37 are formed. Subsequently, as illustrated in Fig. 26D(H), the chip carrier substrate 38M on which the release layer 39M is formed is prepared. The chip carrier substrate 38M is provided along the insulating layer 33M such that the release layer 39M and the pads 37 are in contact with each other. Subsequently, as illustrated in Fig. 26D(I), the halfway-processed chip carrier substrate 38M" and the halfway-processed release layer 39M" are separated. Subsequently, as illustrated in Fig. 26D(J), the insulating layer 33M is covered by the first mold resin layer portion 32M and the adhesive layer 36M. Consequently, the redistribution layer chip intermediate is formed. The multiple redistribution layer chips 30 are cut out of the redistribution layer chip intermediate.

Fig. 27 illustrates a semiconductor package intermediate 1M" according to another modification. The semiconductor package intermediate 1M" includes the interposers 20, the redistribution layer chips 30 adjacent to the interposers 20, and the support carrier substrate 50P that supports the interposers 20 and the redistribution layer chips 30. The redistribution layer chips 30 are manufactured by performing the processes described with reference to Fig. 26C and Fig. 26D and includes the pads 37 before being incorporated into the interposer 20. Fig. 27 illustrates only a portion of the semiconductor package intermediate 1M". In practice, the semiconductor package intermediate 1M" includes the interposer layer 20M that includes the multiple interposers 20, the multiple redistribution layer chips 30 adjacent to the multiple interposers 20, and the support carrier substrate 50P that supports the multiple interposers 20 and the redistribution layer chips 30.

As for the semiconductor package intermediate 1M", the interposer layer 20M has a multilayer structure and includes a first interposer layer 20M1 and a second interposer layer 20M2 that is stacked on the first interposer layer 20M1. The redistribution layer chips 30 overlap the first interposer layer 20M1 and are adjacent to the second interposer layer 20M2 in this state.

Fig. 28 illustrates an example of a method of manufacturing the semiconductor package intermediate 1M". As illustrated in Fig. 28(A), the support carrier substrate 50P on which the first interposer layer 20M1 is formed is prepared. Subsequently, as illustrated in Fig. 28(B), the redistribution layer chips 30 are provided on the first interposer layer 20M1. Subsequently, as illustrated in Fig. 28(C), the second interposer layer 20M2 is provided so as to surround the redistribution layer chips 30. Subsequently, the connection conductive portions 16a and the pads 16 are formed on the second interposer layer 20M2. The connection conductive portions 16a and the pads 16 can be formed in the same process as the process described with reference to Fig. 25.

The semiconductor package intermediate 1M" illustrated in Fig. 27 and Fig. 28 described above includes the interposers 20, the redistribution layer chips 30 adjacent to the interposers 20, and the support carrier substrate 50P that supports the interposers 20 and the redistribution layer chips 30. More specifically, the interposers 20 have a multilayer structure, and some layers that are included in the interposers 20 are adjacent to the redistribution layer chips 30. Needless to say, as for a semiconductor package that is formed by using the semiconductor package intermediate 1M", some layers that are included in the interposer 20 are adjacent to the redistribution layer chip 30.

Fig. 29 illustrates a modification to the redistribution layer chip in Fig. 5. In an example illustrated in Fig. 29, the first wirings 35 in the first redistribution layer 34 are covered by an inorganic film 35a. The inorganic film 35a has the insulation properties. For example, the inorganic film 35a can be composed of silicon oxide (SiO₂) or silicon nitride (SiN). The inorganic film 35a reduces a loss of electric energy when a high frequency current flows. The dielectric tangent of the insulating layer 33 is preferably 0.01 or less. In this case, the inorganic film 35a and the low dielectric tangent of the insulating layer 33 enable the loss of the electric energy to be effectively reduced. The insulating layer 33 may be composed of polyimide. In the illustrated example, the inorganic film 35a covers the exposed portions of the first wirings 35 that are provided on the surface of the release layer 39. The exposed portions of the first wirings 35 correspond to the side surfaces and front surfaces of the first wirings 35 except for the back surfaces of the first wirings 35 in contact with the surface of the release layer 39, and portions that are connected to the other conductive portions are not covered by the inorganic film 35a. In the illustrated example, the inorganic film 35a entirely covers portions of the surface of the release layer 39 at which the first wirings 35 are not provided. Consequently, the inorganic film 35a covers portions of the surface of the release layer 39 that are located between the first wirings 35 adjacent to each other. The inorganic film 35a also covers portions of the surface of the release layer 39 from the outer edge thereof to the first wiring 35 that is located at the outermost circumference. In the illustrated example, the multiple first wirings 35 are provided in the line-and-space pattern, and the line widths of the first wirings 35 are equal to the distance between the first wirings 35 adjacent to each other and is, for example, 1.5 µm. The aspect ratios of the first wirings 35 are about 2.5. However, dimensional conditions are not particularly limited. The inorganic film 35a may or may not entirely cover the surface of the release layer 39. For example, a portion of the inorganic film 35a may be removed in the state illustrated in Fig. 29, and consequently, the inorganic film 35a may not cover the portions of the surface of the release layer 39 from the outer edge of the release layer 39 to the first wiring 35 that is located at the outermost circumference.

### (Example of Product to which Semiconductor Package is Mounted)

Fig. 30 illustrates examples of a product to which the semiconductor package 1 is mounted. The semiconductor package 1 can be used for various products. For example, the semiconductor package 1 is mounted to a notebook personal computer 110, a tablet terminal 120, a mobile phone 130, a smartphone 140, a digital video camera 150, a digital camera 160, a digital clock 170, or a server.

Multiple components disclosed according to the embodiment and the modifications described above can be appropriately combined as needed. Some components may be removed from all of the components disclosed according to the embodiment and the modifications described above.

### Reference Signs List

1, 1', 1", 1‴ -semiconductor package
1M -semiconductor package intermediate
14 -through-electrode
15 -second wiring
16 ·pad
20 -interposer
20A -first surface
20B -second surface
20E -second conductive portion
20M -interposer layer
21 -through-portion
22 -interposer insulating layer
22A -through-hole
24 -second redistribution layer
30 -redistribution layer chip
30' pre-incorporation redistribution layer chip
30A -first surface
30B -second surface
30E -first conductive portion
31 -redistribution element
31M -redistribution element portion
31A -first surface
31B -second surface
32 -first mold resin layer
32M -first mold resin layer portion
32A -through-hole
32E -through-electrode
33 -insulating layer
33M -insulating layer
34 -first redistribution layer
34M -redistribution layer group
35 -first wiring
36 -adhesive layer
37 ·pad
38 -chip carrier
38M -chip carrier substrate
39 -release layer
39M -release layer
40 -first semiconductor element
45 -second semiconductor element
50 -support carrier
50P -support carrier substrate
51 -release layer
51M -release layer
60 -second mold resin layer
60M -second mold resin layer portion
70 -second insulating layer
110 -notebook personal computer
120 -tablet terminal
130 -mobile phone
140 -smartphone
150 -digital video camera
160 -digital camera
170 -digital clock
180 -server
300 -redistribution layer chip intermediate
D1 -first direction
D2 -second direction
D3 -third direction

## Claims

1. A semiconductor package comprising:
an interposer;
a redistribution layer chip adjacent to the interposer; and
a semiconductor element that overlaps the interposer and the redistribution layer chip,
wherein the redistribution layer chip includes a redistribution element that has a surface overlapping the semiconductor element and a first mold resin layer that is mounted to an opposite surface of the redistribution element and that contains resin, the opposite surface being opposite the surface of the redistribution element overlapping the semiconductor element,
wherein the redistribution element includes an insulating layer that has an insulation property and a first redistribution layer that is covered by the insulating layer, and the first redistribution layer includes a first conductive portion that is at least partly located on the surface of the redistribution element overlapping the semiconductor element,
wherein the interposer includes a second redistribution layer that includes a second conductive portion that is located on a surface of the interposer overlapping the semiconductor element, and
wherein the semiconductor element is electrically connected to the first conductive portion and the second conductive portion.

2. The semiconductor package according to claim 1, further comprising: a support carrier that faces the semiconductor element with the interposer and the redistribution layer chip interposed therebetween and that supports the interposer and the redistribution layer chip,
wherein the support carrier is separable from the interposer and the redistribution layer chip.

3. The semiconductor package according to claim 1, further comprising: a second mold resin layer that covers the interposer and the redistribution layer chip, that is mounted to the interposer and the redistribution layer chip, and that holds the semiconductor element.

4. The semiconductor package according to claim 1, wherein a linear expansion coefficient of the first mold resin layer is lower than a linear expansion coefficient of the insulating layer.

5. The semiconductor package according to claim 1, wherein a Young's modulus of the first mold resin layer is more than a Young's modulus of the insulating layer.

6. The semiconductor package according to claim 1, wherein bending stiffness of the first mold resin layer is more than bending stiffness of the insulating layer.

7. The semiconductor package according to claim 1, wherein a thickness of the first mold resin layer is more than a thickness of the insulating layer.

8. The semiconductor package according to claim 1, wherein the first mold resin layer contains a particulate filler that is dispersed in the resin.

9. The semiconductor package according to claim 8, wherein thermal conductivity of the filler is more than thermal conductivity of the resin.

10. The semiconductor package according to claim 8, wherein the filler is composed of an inorganic material.

11. The semiconductor package according to claim 8, wherein color of the filler is black.

12. The semiconductor package according to claim 1, wherein the redistribution layer chip further includes a through-electrode that is located in a through-hole that is formed in the first mold resin layer.

13. The semiconductor package according to any one of claims 1 to 12, wherein the first conductive portion includes a first wiring, and the second conductive portion includes a second wiring, and
wherein a line width of the first wiring is less than a line width of the second wiring.

14. The semiconductor package according to any one of claims 1 to 12, wherein the first conductive portion includes a first wiring, and a line width of the first wiring is 10 µm or less.

15. The semiconductor package according to claim 1, wherein the resin that is contained in the first mold resin layer is at least epoxy resin, polyimide, acryl resin, bismaleimide, polybenzoxazole, or benzocyclobutene.

16. A semiconductor package intermediate comprising:
an interposer;
a redistribution layer chip adjacent to the interposer; and
a support carrier substrate that supports the interposer and the redistribution layer chip,
wherein the redistribution layer chip includes a redistribution element and a mold resin layer that is mounted to the redistribution element and that contains resin,
wherein the redistribution layer chip is mounted to the support carrier substrate with the mold resin layer connected to the support carrier substrate,
wherein the support carrier substrate is separable from the interposer and the redistribution layer chip, and
wherein the redistribution element includes an insulating layer that has an insulation property and a first redistribution layer that is covered by the insulating layer, the first redistribution layer includes a first conductive portion that is at least partly located on a surface opposite a surface of the redistribution element to which the mold resin layer is mounted, and the interposer includes a second redistribution layer that includes a second conductive portion that is located on a surface opposite a surface that faces the support carrier substrate.

17. A redistribution layer chip comprising:
a redistribution element that includes an insulating layer having an insulation property and a redistribution layer covered by the insulating layer and that has a first surface and a second surface opposite the first surface, the redistribution layer including a conductive portion that is at least partly located at the first surface; and
a mold resin layer that is mounted to the second surface and that contains resin.

18. The redistribution layer chip according to claim 17, further comprising: an adhesive layer that is mounted to a surface opposite a surface of the mold resin layer that is mounted to the second surface, wherein the adhesive layer has heat-sensitive adhesiveness, or photosensitive adhesiveness, or pressure-sensitive adhesiveness.

19. A redistribution layer chip intermediate comprising:
a redistribution element portion that includes an insulating layer having an insulation property and multiple redistribution layers covered by the insulating layer and that has a first surface and a second surface opposite the first surface, each of the multiple redistribution layers including a conductive portion that is at least partly located at the first surface;
a mold resin layer portion that is mounted to the second surface and that contains resin; and
a chip carrier substrate that is joined to the first surface.

20. A method of manufacturing a semiconductor package, the method comprising:
a step of placing a redistribution layer chip adjacent to an interposer; and
a step of mounting a semiconductor element that overlaps the interposer and the redistribution layer chip,
wherein the redistribution layer chip includes a redistribution element that has a surface overlapping the semiconductor element and a first mold resin layer that is mounted to an opposite surface of the redistribution element and that contains resin, the opposite surface being opposite the surface of the redistribution element overlapping the semiconductor element,
wherein the redistribution element includes an insulating layer that has an insulation property and a first redistribution layer that is covered by the insulating layer, the first redistribution layer includes a first conductive portion that is at least partly located on the surface of the redistribution element overlapping the semiconductor element, and the interposer includes a second redistribution layer that includes a second conductive portion that is located on a surface of the interposer overlapping the semiconductor element, and
wherein at the step of mounting the semiconductor element, the semiconductor element is electrically connected to the first conductive portion and the second conductive portion.

21. A method of manufacturing a semiconductor package intermediate, the method comprising:
a step of preparing a support carrier substrate;
a step of forming an interposer above the support carrier substrate; and
a step of mounting, to the support carrier substrate, a redistribution layer chip adjacent to the interposer,
wherein the redistribution layer chip includes a redistribution element and a mold resin layer that is mounted to the redistribution element and that contains resin, and the redistribution layer chip is mounted to the support carrier substrate with the mold resin layer connected to the support carrier substrate,
wherein the support carrier substrate is separable from the interposer and the redistribution layer chip, and
wherein the redistribution element includes an insulating layer that has an insulation property and a first redistribution layer that is covered by the insulating layer, the first redistribution layer includes a first conductive portion that is at least partly located on a surface opposite a surface of the redistribution element to which the mold resin layer is mounted, and the interposer includes a second redistribution layer that includes a second conductive portion that is located on a surface opposite a surface that faces the support carrier substrate.
